(19)

Europäisches
Patentamt
European
Patent Office
Office européen
des brevets

(11) **EP 1 275 200 B1**

(12) **EUROPEAN PATENT SPECIFICATION**

(45) Date of publication and mention
of the grant of the patent:
**10.09.2008 Bulletin 2008/37**

(51) Int Cl.:
*H03G 3/00* *(2006.01)*

(21) Application number: **01927022.2**

(86) International application number:
**PCT/US2001/012250**

(22) Date of filing: **13.04.2001**

(87) International publication number:
**WO 2001/080423 (25.10.2001 Gazette 2001/43)**

(54) **METHOD AND APPARATUS FOR DYNAMIC SOUND OPTIMIZATION**

VERFAHREN UND VORRICHTUNG ZUR DYNAMISCHEN SCHALLOPTIMIERUNG

PROCEDE ET APPAREIL D'OPTIMISATION DYNAMIQUE DU SON

(84) Designated Contracting States:
**AT BE CH CY DE DK ES FI FR GB GR IE IT LI LU
MC NL PT SE TR**

(30) Priority: **14.04.2000 DE 10018666
21.07.2000 DE 10035673**

(43) Date of publication of application:
**15.01.2003 Bulletin 2003/03**

(73) Proprietor: **HARMAN INTERNATIONAL
INDUSTRIES, INCORPORATED
Northridge
California 91329 (US)**

(72) Inventor: **CHRISTOPH, Markus
94315 Straubing (DE)**

(74) Representative: **Grünecker, Kinkeldey,
Stockmair & Schwanhäusser
Anwaltssozietät
Leopoldstraße 4
D-80802 München (DE)**

(56) References cited:
**EP-A- 0 319 777          EP-A- 0 964 512
DE-A- 19 832 472          US-A- 5 450 494**

- **HARMA A: "Implementation of frequency-warped
recursive filters" SIGNAL PROCESSING,
AMSTERDAM, NL, vol. 80, no. 3, March 2000
(2000-03), pages 543-548, XP004188172 ISSN:
0165-1684**
- **WANG PENG ET AL: "Bark scale equalizer design
using warped filter" 2001 IEEE INTERNATIONAL
CONFERENCE ON ACOUSTICS, SPEECH, AND
SIGNAL PROCESSING. PROCEEDINGS (CAT.
NO.01CH37221), 2001 IEEE INTERNATIONAL
CONFERENCE ON ACOUSTICS, SPEECH, AND
SIGNAL PROCESSING. PROCEEDINGS, SALT
LAKE CITY, UT, USA, 7-11 MAY 2001, pages
3317-3320 vol.5, XP002189832 2001, Piscataway,
NJ, USA, IEEE, USA ISBN: 0-7803-7041-4**
- **GULZOW T ET AL: "Comparison of a discrete
wavelet transformation and a nonuniform
polyphase filterbank applied to spectral-
subtraction speech enhancement" SIGNAL
PROCESSING. EUROPEAN JOURNAL DEVOTED
TO THE METHODS AND APPLICATIONS OF
SIGNAL PROCESSING, ELSEVIER SCIENCE
PUBLISHERS B.V. AMSTERDAM, NL, vol. 64, no.
1, 1998, pages 5-19, XP004108820 ISSN:
0165-1684**

**Description**

FIELD OF THE INVENTION

The invention relates to a device and a method for the noise-dependent adjustment of a desired acoustic signal radiated at a monitoring point, and also to an adaptive warped digital filter for use therein.

BACKGROUND OF THE INVENTION

When music or speech is offered in a noise-filled environment via an electro-acoustic system, pleasurable hearing is generally muddied by the background noise. A noise-filled space in which music and speech are frequently heard is, for instance, the passenger compartment of a motor vehicle. The background noise can originate from the engine, the tires, blower and other motors, wind noise, and other units in the motor vehicle and be a function of the speed, road conditions, and the operating conditions in the motor vehicle. The occupant of the motor vehicle reacts to this time-varying backdrop by accordingly turning the volume control to adjust the desired signals offered in the form of music or speech.

EP 0 319 777 A2 discloses a method for an automatic volume control corresponding to ambient noise by modeling a loudspeaker - microphone transfer function that is adapted by an evaluation of the correlation of the desired signal and a signal representing the sum of a desired sound and ambient noise.

In the US 5,450,494A an automatic volume control device for controlling the volume of an audio device based on ambient noise is disclosed that detects both the sound produced by the audio device and the ambient noise. Adaptive filtering s performed based on signals from the audio device to obtain an ambient noise signal and a corresponding ambient noise level according to which the volume of the audio device is adapted.

DE 43 14 451 A1 discloses a control device for controlling the volume of a car radio by means of detected microphone signals including perturbation amplitudes.

A method and a device for the dynamic optimization of sound are known from U.S. Patents Nos. 5,434,922 and 5,615,270, both entitled "Method and Apparatus for Dynamic Sound Optimization." These patents disclose a method and device in which the volume of the desired signal is automatically adjusted as a function of the background noise. The overall sound in the monitored space is evaluated by means of a microphone so that the signal corresponding to the overall sound is fed to an extractor which extracts the noise-signal component from the overall sound. In a subsequent amplification-evaluation stage, this extracted noise-signal component is compared with the original signal from the sound source. The results of this comparison are then used for setting the volume of the desired acoustic signal.

What is problematic with the way in which the noise-signal component is extracted is that components of the desired signal are also contained in the extracted noise-signal component. Thus, the level of the extracted noise signal is higher than the actual noise level and if only the extracted noise signal is used to adjust volume, a higher volume is set which increases the volume. The effect of a higher volume set is that the desired-signal component remaining in the extracted noise-signal component also increases. This phenomenon, also described as "gain chase," would thereby end in the maximum possible volume level, so that either the listener positioned in the motor vehicle must manually intervene, or - as in U.S. Patent nos. 5,434,922 and 5,615,270 -- implement a relatively more expensive system in order to suppress the "gain chase."

Adaptive networks such as adaptive digital filters are important in many areas of time-discrete signal processing, particularly in the areas of system analysis, echo suppression in data transmission systems, speech processing and electro-acoustics. The characteristic feature of such adaptive networks compared to fixed networks is that the network parameters establishing the transmission characteristics are optimally set with respect to a specified quality function. One such quality function is realized, for example, by minimizing the mean squared error (MSE) of the output signal of the adaptive network with respect to a reference signal.

An adaptive digital filter consists, for example, of a delay line with a specific quantity of weighted taps along its length. The weighted output signals of all taps are summed up in one output signal. The weightings of the signals of the individual taps are thus continuously adjusted in order to minimize an error signal. The error signal can be generated, for example, if the output signal of the filter is subtracted from a reference signal. In addition to this method, described as a least mean squares (LMS) method, there are numerous additional processes for optimizing the output signal to a reference signal. Additional processes might include the following methods: Recursive Least Squares, QR Decomposition Least Squares, Least Squares Lattice, QR Decomposition Lattice or Gradient Adaptive Lattice, Zero Forcing, Stochastic Gradient, and so forth. These and additional processes are described in Haykin, Adaptive Filter Theory, Prentice Hall, 2nd edition 1991, or in J. G. Proakis, Digital Communication, McGraw Hill, 1995, pages 634 to 676, or in D. A. Pierre, Optimization Theory with Applications, Wiley and Sons, New York 1969, among other places.

An important application area for adaptive filters is the field of dynamic sound optimization of sound systems installed in acoustically unfavorable environments. A particularly unfavorable environment is the passenger compartment of a motor vehicle, since numerous and time-variable background noises add to the already unfavorable characteristics of the enclosure. U.S Patent Nos. 5,434,922 and US 5,615,270 demonstrate processes and configuration to improve sound quality in the motor vehicle interior using adaptive filters. The more complex the acoustics and the greater the noise component in the enclosure, the more complex and expensive are the required adaptive filter or filters for acoustical optimization. On the other hand, the budget for many applications, particularly in the motor vehicle, is very limited, especially for adaptive filters. Therefore, it is often the case that either the budget for a particular application must be increased, or a reduction in acoustical quality must be accepted.

SUMMARY OF THE INVENTION

A device for the noise-dependent adjustment of a sound output radiated by a sound radiator in an environment in accordance with an embodiment of the invention has a signal source that provides a desired electrical signal and a regulating apparatus to which the desired electrical signal is provided that produces a processed desired electrical signal from the desired electrical signal. The processed desired electrical signal is provided to the sound radiator that produces the sound output therefrom. The device also has a sound pickup that picks up sound in the environment, the sound in the environment having a component related to the sound output of the sound radiator and an acoustic noise component. The sound pickup provides a monitoring signal that includes a component corresponding to the sound output component of the sound in the environment and a component corresponding to the acoustic noise component. The device further has an extractor to which the monitoring signal is provided that generates at least an extracted noise signal representative of the acoustic noise component of the monitoring signal and a controller to which the extracted noise signal and at least one additional signal derived from the monitoring signal are provided. The controller generates a control signal that is provided to the regulating apparatus. The regulating apparatus varies the processed desired electrical signal in response to the control signal.

In an embodiment of the invention, a state signal can be applied to the controlling apparatus. With it, the volume and/or other variables of the desired signal can be influenced by additional information, e.g., not only from the volume setting (by means of the volume control, for instance) but also, in the case of installation in motor vehicles, from the vehicle speed and engine speed, for example.

The extractor preferentially has at least one adaptive filter. This can, for example, function according to the least mean squares method.

For extracting the noise-signal component from the monitoring signal, the extractor can be connected to the signal source, from which it receives the desired signal, or be connected to the signal-processing apparatus, from which it receives the processed desired signal.

The method according to invention appropriately provides for the generation of a desired electrical signal, the processing of it as a function of a control signal, and the generation of the desired acoustic signal from the processed desired electrical signal. With that, an electrical monitoring signal, defined by the desired acoustic signal on which an acoustic noise signal is superimposed, is audited at the monitoring point; the noise-signal component contained in the monitoring signal is then extracted; and the noise-signal component contained in the monitoring signal is combined with a signal derived from the monitoring signal, producing the control signal.

Signals derived from the monitoring signal can, in turn, correspond to the sum of desired-signal component and spurious-signal component of the monitoring signal and/or to the signal derived from the monitoring signal, i.e., the desired-signal component.

Further areas of applicability of the present invention will become apparent from the detailed description provided hereinafter. It should be understood that the detailed description and specific examples, while indicating the preferred embodiment of the invention, are intended for purposes of illustration only and are not intended to limit the scope of the invention.

BRIEF DESCRIPTION OF THE DRAWINGS

The present invention will become more fully understood from the detailed description and the accompanying drawings, wherein:

FIG. 1 shows a first embodiment of a device according to the present invention;
FIG. 2 shows a second embodiment of a device according to the present invention;
FIG. 3 shows an adaptive filter for use with the device according to the first embodiment of the invention shown in FIG. 1;
Figure 4 shows the basic structure of an adaptive filter,
Figure 5 shows a filter unit in an adaptive digital filter according to the present invention;
Figure 6 shows the phase response or frequency distortion function of a filter element of an adaptive digital filter;

Figure 7 shows the frequency resolution of an adaptive digital filter for various phase responses;
Figure 8 shows of a device for sound-dependent matching of a desired signal;
Figure 9 shows of a device for sound-dependent matching of a desired signal ;
Figures 10 shows an embodiment of an extractor with adaptive digital filters in a device for sound-dependent matching of a desired signal;
Figure 11 shows an embodiment of an all-pass filter for application in an adaptive digital filter;
Figure 12 shows an embodiment of an all-pass filter for application in an adaptive digital filter;
Figure 13 shows a control device in a device for sound-dependent matching of a desired signal;
Figure 14 shows a control device in a device for sound-dependent matching of a desired signal;
Figure 15 shows a control device in a device for sound-dependent matching of a desired signal;
Figure 16 shows an embodiment of a device for voice recognition;
Figure 17 shows an embodiment of a control device in a device for sound-dependent matching of a desired signal;
Figure 18 shows an embodiment of a control device in a device for sound-dependent matching of a desired signal;
Figure 19 is a graph showing the performance of the devices of Figures 17 and 18;
Figure 20 shows an embodiment of a control device in a device for sound-dependent matching of a desired signal;
Figure 21 shows an embodiment of a control device in a device for sound-dependent matching of a desired signal;
Figure 22 is a graph showing the performance of the device of Figure 21;
Figure 23 shows an embodiment of a control device in a device for sound-dependent matching of a desired signal;
Figure 24 shows an embodiment of a control device in a device for sound-dependent matching of a desired signal;
Figure 25 is a graph showing the performance of the device of Figure 24;
Figure 26 shows a device for dynamic sound optimization;
Figure 27 shows the processing block of the device of Figure 26;
Figure 28 shows a device for dynamic sound optimization;
Figure 29 shows the processing block of the device of Figure 28;
Figure 30 shows the determination of multiple input signals ($S_c$) for use in of the devices of Figures 26 and 28;
Figure 31 shows a representative transfer function for the transfer function block of the processing block of Figure 29;
Figure 32 shows a dynamic controller of the device of Figure 28;
Figure 33 shows a dynamic controller of the device of Figure 28; and
Figure 34 is a graph showing the performance of the device of Figure 33.

DETAILED DESCRIPTION OF THE PREFERRED EMBODIMENTS

The following description of the preferred embodiment(s) is merely exemplary in nature and is in no way intended to limit the invention, its application, or uses.

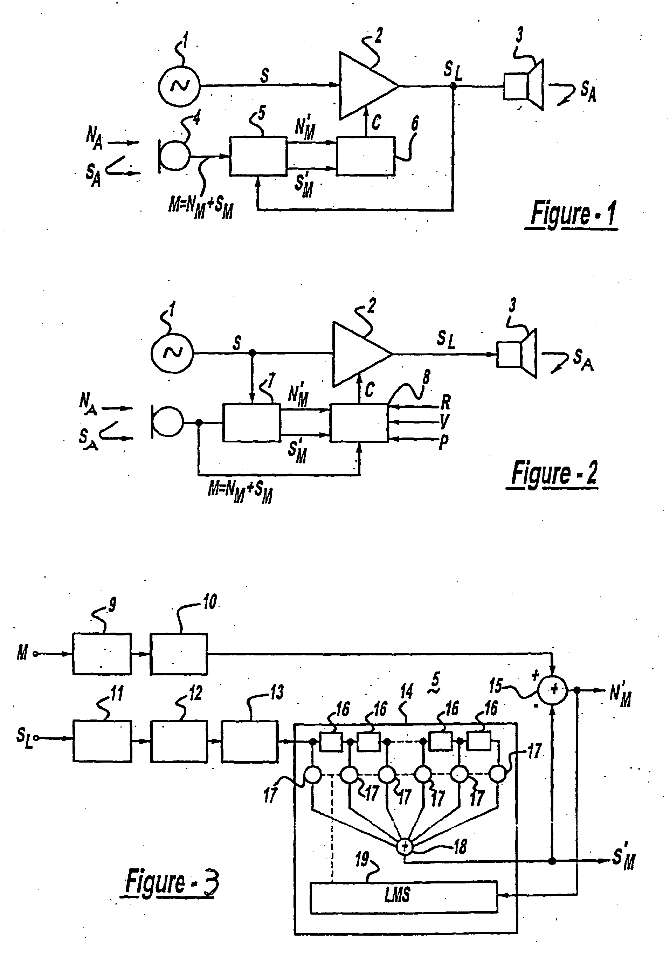

The first embodiment of a device according to the present invention is shown in FIG. 1. The device comprises a signal source 1 such as a CD player, an MP3 player, a radio receiver, an audio cassette player or other sound carrier/reproduction apparatus, which emits a desired or source signal S. The desired signal S is fed to a regulating apparatus 2, which is connected in series at the output end of the sound source 1. A control signal C varies the volume and/or other signal characteristics, such as degree of compression, sound, and from the desired signal S, the regulating apparatus 2 produces a processed desired signal $S_L$. The processed desired signal $S_L$ is then fed to a sound-radiating apparatus or transducer 3 which produces a desired acoustic signal $S_A$ from the processed desired electrical signal $S_L$. In addition to one or a plurality of speakers, the sound-radiating apparatus may also have related output stages, as well as appropriate digital-analog converters in the case of digital controlling.

A microphone 4 serving as a sound pickup receives the desired acoustic signal $S_A$ and an acoustic noise signal $N_A$, which, in the case of a motor vehicle's passenger compartment may be composed of road noise, engine noise and/or other noise in the passenger compartment. In the microphone 4, the acoustic noise signal $N_A$ is superimposed on the desired electrical signal $S_A$. The microphone 4 accordingly generates an electrical monitoring signal M from the desired acoustic signal $S_A$. and the acoustic noise signal $N_A$. Following its conversion from the desired acoustic signal $S_A$ and the acoustic noise signal $N_A$ via the microphone, the electrical monitoring signal M is equal to the sum of the spurious or noise signal $N_M$ and the desired signal $S_M$. The monitoring signal M is applied to an extractor 5, which generates an extracted desired signal $S'_M$ and an extracted noise signal $N'_M$ from the monitoring signal M. The control signal C is then formed from extracted desired signal $S'_M$ and extracted noise signal $N'_M$ by means of a controlling apparatus 6.

The reproduction signal path extends from the signal source 1 to the sound-radiating apparatus 3. Sound reproduction, such as volume, tone, and compression, etc., may be influenced by the regulating apparatus 2.

The regulating apparatus 2 is controlled by the control signal C which is derived from the processed desired signal $S_L$ and the monitoring signal M which are fed to the extractor 5. The desired electrical signal $S_M$ and the noise signal $N_M$, correspond to the respective desired acoustic signal $S_A$ and the acoustic noise signal $N_A$ received by microphone 4. Accordingly, the extracted desired signal $S'_M$ and the extracted noise signal $N'_M$ are obtained by extractor 5.

The extracted noise signal $S'_M$ essentially corresponds to the desired acoustic signal $S_A$, which is folded with the pulse response from the space enclosing the monitoring point. The signal $N'_M$ corresponds to the prevailing ambient noise.

In order to minimize the error contained in the extracted noise signal $N'_M$, the extracted desired signal $S'_M$ also is fed into the controlling apparatus 6. The extracted desired signal $S'_M$ simulates the desired-signal component, namely, the signal $S_M$ in the monitoring signal M. The extractor 5 generates the extracted desired signal $S'_M$ from the processed desired signal $S_L$ such that the processed desired signal $S_L$ is folded with the spatial pulse response simulated in the extractor 5. The desired signal $S'_M$ thus nearly approximates the desired acoustic signal $S_A$.

A second embodiment of the present invention is shown in FIG. 2. The second embodiment of FIG. 2 is similar to the embodiment of FIG. 1, but in place of the extractor 5, an extractor 7 is provided. Extractor 7 does not receive the processed desired signal $S_L$, but does receive the desired signal S from the output of the signal source 1. A controlling apparatus 8 replaces controlling apparatus 6 of FIG. 1. Besides being triggered by the extracted desired signal $S'_M$ and the extracted noise signal $N'_M$, controlling apparatus 8 is also triggered by the monitoring signal M as well as by state signals R, V and P. The state signal R refers to the current engine speed, the state signal V to the speed of the vehicle, and the state signal P to the volume control setting. With respect to the subject invention, the extracted desired signal $S'_M$ is compared within the controlling apparatus 6 or 8 for forming the control signal C.

The particular advantage of using the extracted desired signal $S'_M$ compared with the desired signal S radiated from the signal source 1 or the processed desired signal $S_L$ is that the extracted desired signal $S'_M$ corresponds to the source signal prevailing in the monitored space, as it is picked up by the microphone 4. $S'_M$ best reproduces the true conditions of the monitored space. The advantage in generally using the processed desired signal $S_L$ as opposed to the desired signal S from sound source 1 is that the modifications made to the desired signal S in the regulating apparatus 2 do not have to be duplicated by the extractor 5.

Extractor 5 and extractor 7 include an adaptive filter selected from a plurality of known possible adaptive filters such as LMS filters, RLS filters, QR decomposition LS filters, LS lattice filters, QR decomposition lattice filters, gradient adaptive lattice filters, etc. The selected adaptive filter preferably functions according to the methods of the least mean square (LMS) or the method of the delayed least mean square (DLMS), so that they can be utilized very effectively and efficiently with the aid of a digital signal processor.

Figure 3 shows an exemplary embodiment for an adaptive filter used in the extractor 5 according to Figure 1. Generally, a specific adaptive filter would preferably be required for every spatially-located sound-reproducing device which is triggered by the processed desired signal $S_L$. Because of limited available computer power, such a configuration is not practical. An error occurs if the extracted noise signal $S'_M$ is calculated using only one or two adaptive filters and not, as is preferred, by using the same number of adaptive filters as there are sound-reproducing apparatuses in the entire system. This error becomes evident in the extracted noise signal $N'_M$. The error can be minimized, however, if the sum signal of the processed amplifier output signals or the speaker triggering signals is used for extracting the desired signal $S'_M$.

In addition to this, the filter core of the adaptive filter is a conventional filter, such as a finite impulse response (FIR) or infinite impulse response (IIR) filter. As a result, errors again occur which become evident in the extracted noise signal $N'_M$. In the exemplary embodiment, a conventional FIR filter is used as the filter core of the adaptive filter in the extractor 5 of FIG 1. Extractor 5 enables a fast and simple calculation of the coefficients using the LMS method (gradient decrease method).

With reference to FIG. 3, the extractor 5 includes a sampling rate reduction apparatus 9 to which the monitoring signal M is fed and which is connected in series to the input of a filter 10, which may be an equalizer. A second signal path for the processed desired signal $S_L$ appropriately includes a sampling rate reduction apparatus 11 the output of which is input to a filter 12, which may be an equalizer. Filter 12 connects in series to a delay apparatus 13. The output of delay apparatus 13 is input to filter core 14, which is implemented as an adaptive filter. The output signal of filter core 14 is subtracted from the output signal of the filter 10 by a subtractor 15. The extracted noise signal $N'_M$ is output from subtractor 15. The extracted desired signal $S'_M$ can be tapped at the output of the filter core 14.

The filter core 14 essentially comprises a non-recursive filter component having a plurality of delay elements 16 connected in series. The input taps of delay elements 16 are input to an analog adder 18 through coefficient elements 17 interposed between delay elements 16. The output of the analog adder 18 is the output of the filter core 14 and, accordingly, represents the extracted desired signal $S'_M$. The coefficient elements 17 are simultaneously controlled by a coefficient calculation apparatus 19 which functions according to the method of the least mean squares (LMS). Using the extracted noise signal $N'_M$ as a basis, the coefficient calculation apparatus 19 adjusts the coefficient elements 17.

For the filter core 14 having a FIR filter structure, the frequency resolution df can be calculated from filter length l:

$$df = f_a/l,$$

where $f_a$ is the sampling frequency in Hertz, I the filter length in taps, and df the frequency resolution in Hertz. It is immediately evident from the equation how the filter length I and the sampling frequency $f_a$, affects df and the quality of the adaptive filter. The greater the filter length I or the smaller the sampling frequency $f_a$, the better the frequency resolution df, that is, the interaction between the individual spectral lines. The quality or the error increases or decreases, respectively, in the extracted noise signal $N'_M$ output by the adaptive filter. Limiting the wave band being analyzed to an upper cut-off frequency of aground 1 kHz is tolerable for many installations, such as in a motor vehicle. All signals supplied to either extractor 5 or 7 can therefore be sub-sampled, for example at a new sampling frequency of $f_a$ = 2 kHz. Compared with the original sampling frequency $f_a$, not only is there a gain in computing time, but also a significant increase in frequency resolution using a constant filter length. Consequently, implementation expense is drastically reduced.

Although the adaptive filter was explained with regard to the exemplary embodiment according to FIG. 1, it can, however, be applied in the same way for the specific embodiments according to FIG. 2.

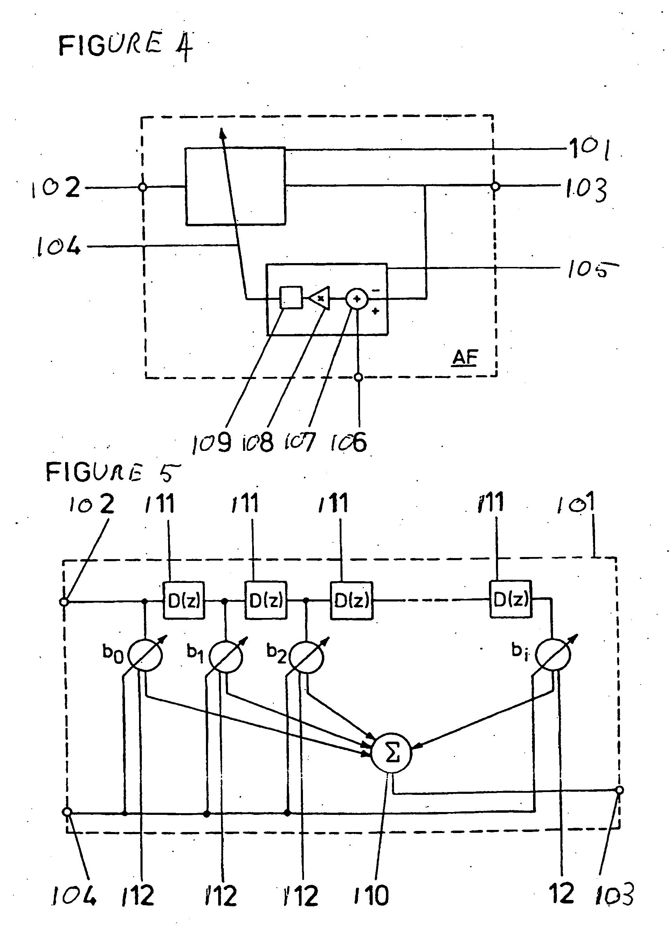

Turning now to Figure 4, a filter unit 101 receives an input signal 102, and filters the input signal to generate an output signal 103. The transmission behavior of filter unit 101 is variable by a control signal 104. A control unit 105 generates control signal 104 in accordance with the output signal of filter unit 101 and a reference signal 106. The control unit 105 functions according to the least mean squares (LMS) method and includes a subtractor 107, which subtracts output signal 103 from reference signal 106, and an amplifier 108 receiving and amplifying the output of the subtractor 107. Amplifier 108 provides a predetermined amplification. By applying the least mean squares method a delay element 109 can be inserted downstream of amplifier 108 to delay the output of amplifier 108. Any filter in which the coefficients can be varied may be implemented as filter unit 101, thus ensuring that the transmission behavior of the filter unit 101 can be regulated.

Figure 5 shows a warped adaptive filter not being part of the invention but helpful to understand the advantages of the present invention more completely. According to Figure 5, a finite impulse response (FIR) filter includes a global analog adder 110 at the output. The inputs to analog adder 110 are attached to the taps of a delay line formed by delay elements 111 via controllable coefficient elements 112 which are inserted between the taps and controllable coefficient elements 112. Control of coefficient elements 112 occurs through control signal 104. Filter elements with variable phase response are preferably embodied as all-pass filters of the first order to implement delay elements 111 and have a transfer function D(z), where

$$D(z) = (Z^{-1} - \lambda) / (1 - \lambda Z^{-1})$$

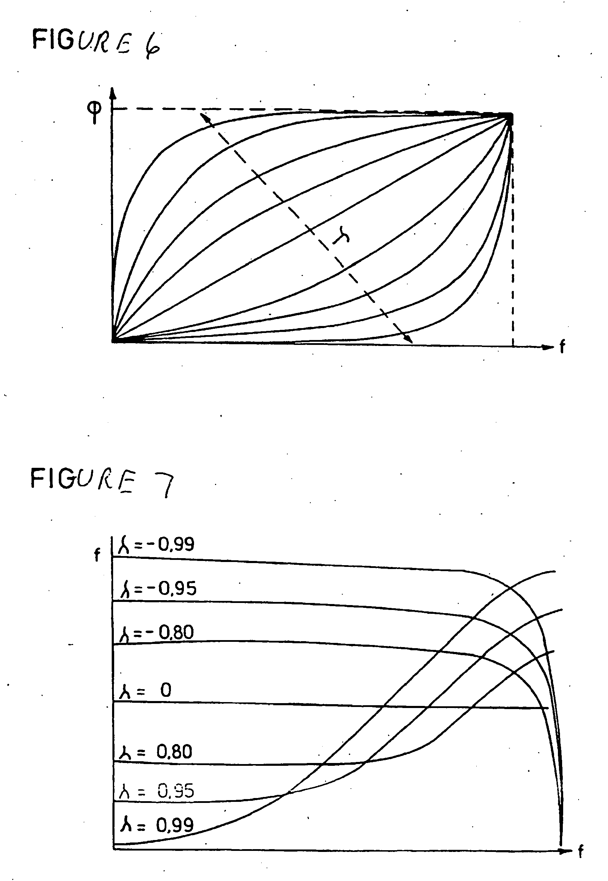

The phase response $\varphi$ of the filter element 111 can be set using filter coefficient $\lambda$ of the filter element 111. The frequency distortion function of filter unit 101 of Figure 5 can be set via the filter coefficient or warping parameters $\lambda$ of the all-pass filter element 111. The linear frequency axis is converted to a new warped frequency axis using the phase response of the all-pass filter elements 111. This phase response exclusively depends on the coefficients $\lambda$. Figure 6 shows how the frequency resolution varies in accordance with the frequency and the coefficient or warping parameters $\lambda$. Figure 7 demonstrates more specifically the dependence of frequency resolution upon the coefficient or warping parameters $\lambda$.

In Figure 7, the frequency resolution $\Delta f$ is shown using frequency f and depends upon different values of the filter coefficients $\lambda$. The turning point frequency, $\lambda = 0$, is that frequency at which the frequency resolution equals one. Thus the frequency resolution is calculated as follows:

$$\Delta f_W (f, \lambda) = f_{warp} (f, \lambda) \cdot (1 - \lambda^2) / (1 + \lambda^2 + 2\lambda \cdot \cos (2\pi f_{warp}(f, \lambda) / f_s),$$

with

$$f_{warp} (f, \lambda) = f + (f_s/\pi) \cdot \arctan (\lambda \cdot \sin (2\pi f/f_s) / (1 - \lambda \cdot \cos (2\pi f/f_s))$$

where $f_s$ indicates the sampling frequency, $f_w(f,\lambda)$ the frequency-dependent frequency resolution of the adaptive filter, and $f_{warp} (f, \lambda)$ the new frequency corresponding to the all-pass frequency response.

The turning point frequency $f_{TP}$ is therefore that frequency at which the warped adaptive filter has the same frequency resolution as a conventional filter. This is calculated as follows:

$$f_{TP} = (f_s \, / \, 2\pi \,) \cdot \arccos{(\lambda)}.$$

Note that with a positive filter coefficient $\lambda$, there is an increase in the frequency resolution in the lower frequency range. At the same time there is a degradation compared to conventional filters in the frequency range above the turning point frequency $f_{TP}$.

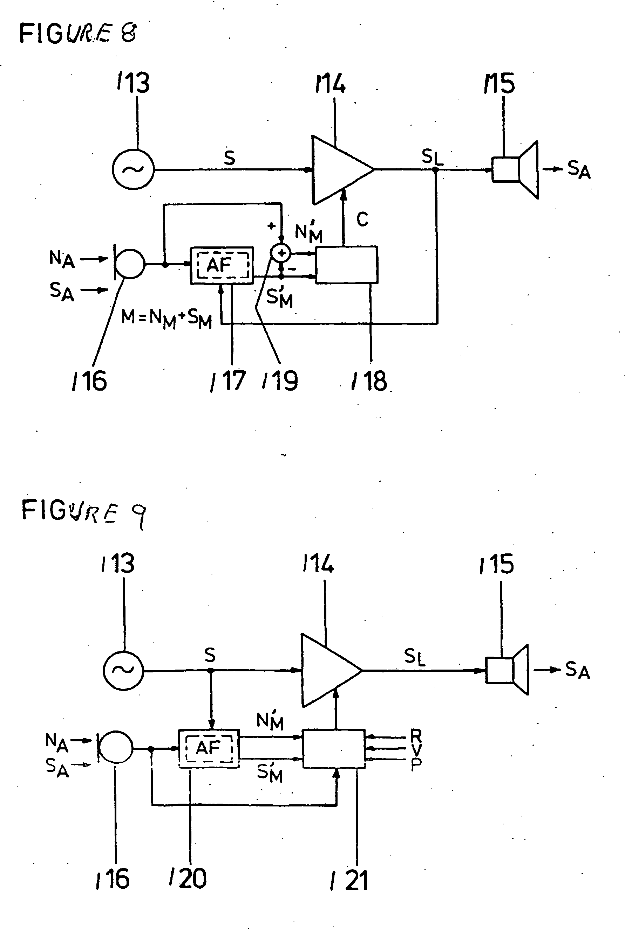

According to the discussed warped adaptive filter, this circumstance is applied advantageously in a device for sound-dependent matching of a projected acoustic desired signal at a monitoring location. Figure 8 shows a device for sound-dependent matching of a radiated acoustic desired signal. A signal source 113, such as a CD player, an MP-3 player, a radio receiver, an audio cassette player, or other sound reproduction device, outputs desired signal S. Desired signal S is fed to regulating unit 114, which modifies the desired signal S in accordance with control signal C and outputs a processed desired signal $S_L$. This processed desired signal $S_L$ is modified in terms of volume and/or other signal characteristics, such as degree of compression, sound tone, etc. The processed desired signal $S_L$ is input to a sound transducer 115, which produces an acoustic desired signal $S_A$ from the processed electrical acoustic desired signal $S_L$. The sound transducer 115 includes one or several loudspeakers, and optionally includes associated output stages corresponding digital-to-analog converters if sound transducer 115 employs digital controls.

The acoustic desired signal $S_A$ is received by a microphone 116 serving as acoustic receiver, receiving an acoustic noise signal $N_A$ overlapped onto the acoustic desired signal $S_A$ The combined signals might be found in a motor vehicle passenger compartment, where vehicle noises, engine noises and other sound disturbances come together. Microphone 116 correspondingly generates an electrical monitored signal from acoustic desired signal $S_A$ and acoustic noise signal $N_A$, which is equal to the sum of noise signal $N_M$ and desired signal $S_M$ after conversion by microphone 116 of the acoustic desired signal $S_A$ and the acoustic noise signal $N_A$. The monitored or microphone signal M and the processed desired signal sol are input to an extractor 117, which generates an extracted desired signal $S'_M$ and an extracted noise signal $N'_M$ from microphone signal M. A control device 118 creates control signal C from the extracted desired signal $S'_M$ and extracted noise signal $N'_M$.

The reproduction signal path extends from signal source 113 to sound transducer 115. The sound reproduction such as volume, tone quality, compression, etc. can be influenced by the regulating unit 114. Control of regulating unit 114 is performed by control signal C, emanating from the processed desired signal $S_L$ and monitored signal M. An electrical desired signal $S_M$ or an electrical noise signal $N_M$ after microphone 116 corresponds to the respective acoustic desired signal $S_A$ and the acoustic noise signal $N_A$. The extracted desired signal $S'_M$ is filtered out from microphone signal M by extractor 117 using the processed desired signal $S_L$. The extracted desired signal $S'_M$ is removed from microphone signal M by subtractor 119 in order to generate the extracted noise signal $N'_M$. Instead of subtractor 119, the output signal of the subtractor 107 in adaptive filter AF, as shown in Figure 4, may be applied to control unit 118 as an extracted noise signal. Microphone signal M can likewise be applied to control unit 118. One skilled in the art will recognize that optional additional filters and/or sampling reduction means may be incorporated into Figure 8. Apart from a residual error, the extracted noise signal $S'_M$ essentially correspond to the acoustic desired signal $S_A$, which is folded in with the impulse response of the enclosure of the monitoring space. The extracted noise signal $N'_M$, apart from a residual error corresponds to the prevailing environmental sounds.

To minimize the error contained in the extracted noise signal $N'_M$ the extracted desired signal $S'_M$ is input into control unit 118. The extracted desired signal $S'_M$ simulates the desired signal component $S_M$ of monitored signal M. Extracted desired signal $S'_M$ is thus generated by the extractor 117 from processed signal $S_L$ in such a way that the processed desired signal $S_L$ is folded in with the simulated environmental impulse response. Thus, the extracted desired signal $S'_M$ corresponds closely to the acoustic desired signal $S_A$.

The example of Figure 9, operates similarly to the one in Figures 8, but omits subtractor 119. The extracted noise signal $N'_M$ is generated directly by extractor 117. Rather than using an extractor 117 which receives the processed desired signal $S_L$, an extractor 120 receives desired signal S directly from the output of signal source 113. In addition, instead of control element 118, control element 121 receives as input monitored signal M as well as status signals R, V, and P, and extracted desired signal $S'_M$ and extracted noise signal $N'_M$. Status signal R relates to the current engine speed, status signal V relates to vehicle speed, and status signal P relates to the setting of the amplifier volume control.

For the examples demonstrated in Figures 8 and 9, in addition to extracted noise signal $N'_M$, the extracted desired signal $S'_M$ is input to control units 118, 121 for the creation of control signal C. The particular advantage of using the extracted desired signal $S'_M$ rather than desired signal S or processed desired signal $S_L$ is that the extracted desired signal $S'_M$ extracted by extractor 117 or 120 from the microphone signal $N_M + S_M$ corresponds to the prevailing source signal in the monitoring environment, as recorded by the recording medium. $S'_M$ reflects the actual conditions of the monitoring environment. Use of processed desired signal $S_L$, however, generally has advantages over desired signal S because the modification of desired signal S performed in regulating unit 114 does not need to be tracked by extractor 117 or 120.

Extractor 117 and extractor 120 employ a warped adaptive filter according to the present invention. Adaptive filters have a number of known uses for control functions, such as can be realized in the quality functions mentioned above. Adaptive filters are preferably used in applications utilizing the least mean square (LMS) algorithm or method or the delayed least mean square (DLMS) algorithm or method. Adaptive filters function very effectively and efficiently using a digital signal processor. In the embodiments of Figures 8 and 9, the warped adaptive filter, described in Figure 5, receives as input signal 102 the desired signal S from source 113 or the processed desired signal $S_L$ from the output of regulating unit 114. Microphone signal M provides the reference signal, such as reference signal 106 of Figure 4.

The use of a warped adaptive filter is especially advantageous when working with high sampling frequencies and a high frequency resolution must be achieved within a specified frequency range using a short filter. When comparing a conventional adaptive filter with a warped adaptive filter, for example using a sampling frequency of 44.1 kHz in the lower frequency range to about 1 kHz and specifying a filter length of 40 taps, at 1 kHz the frequency resolution is 170 Hz using the warped adaptive filter, compared to 1100 Hz using the conventional filter. A warped adaptive filter as just described would have a filter coefficient or warping parameter of $\lambda = 0.9$ at the specified parameters of a sampling frequency of 44.1 kHz and a limit frequency of 1 kHz.

In practice, particularly in a device for sound-dependent matching of an acoustic desired signal, two adaptive warped filters may be implemented. One filter of the two filter system displays the above-described characteristics, and the other filter of the two filter system covers the lower frequency range to about 150 Hz. In this way a comprehensive frequency range splitting is possible at the usual sampling frequency. At a frequency cutoff of 150 Hz, such a filter would have a filter coefficient or warping parameter of $\lambda = 0.99$ at a duration of 40 taps and a sampling frequency of 44.1 kHz.

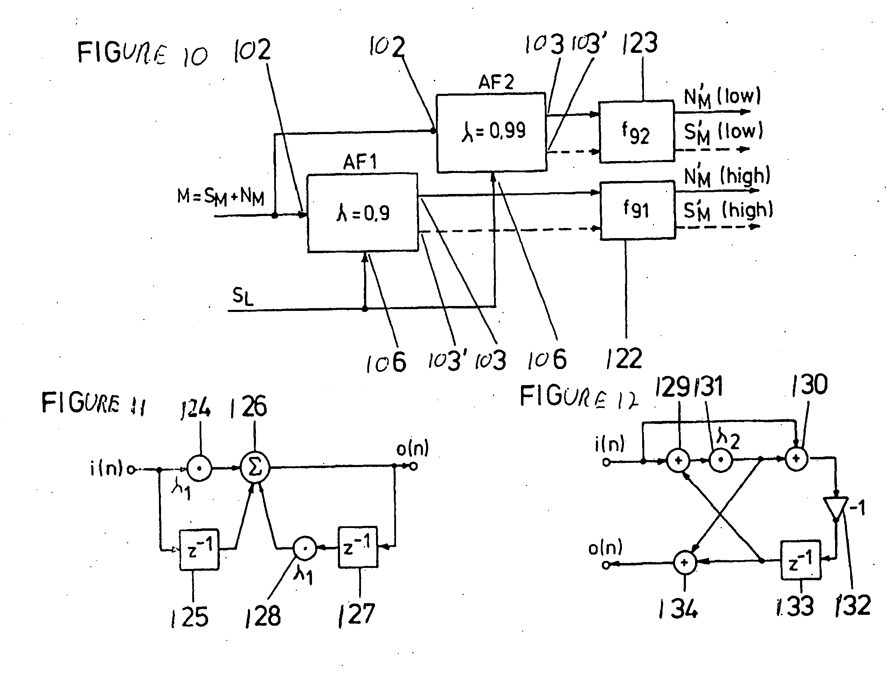

The structure of such a divided warped adaptive filter is shown in Figure 10, which shows two adaptive warped filters AF1 and AF2 of the type shown in Figure 5. Warped adaptive filter AF1 has a warping parameter $\lambda = 0.9$, and warped adaptive filter AF2 has a warping parameter $\lambda = 0.99$. Both filters are controlled on the input side by microphone signal M. The reference signal used is the processed desired signal $S_L$ taken from the output of regulating unit 114. Extracted noise signals with high resolution in the lowest frequency range N'$_M$ (low) and in the low frequency range N'$_M$ (high) are output as signals 103. In the design of warped adaptive filters AF1 and AF2, an additional output signal 103' can be generated, which can then provide the extracted desired signal S'$_M$ (low) with a high resolution at the lowest frequencies or an extracted desired signal S'$_M$(high) with a high resolution for low frequencies. The individual functional ranges are best defined by low-pass filters 122 and 123 downstream of warped adaptive filters AF1 and AF2, where low-pass filter 122 has a higher frequency cutoff fg$_1$, such as 1 kHz, than low-pass filter 123 with a frequency cutoff fg$_2$, such as 150 Hz. Individual signals N'$_M$ (low), S'$_M$ (low N'$_M$(high) and S'$_M$(high) can be processed individually in control units 118 or 121 and then summarized or can be initially summarized, then processed together.

The two-part embodiment of the adapted warped filter shown in Figure 10 achieves a resolution frequency of 1 kHz using a duration of 40 taps and a sampling rate of 170 Hz. By way of comparison, conventional filters having a filter duration of 200 taps would be required at a sampling rate of 170 Hz. In the present invention, extractors 117 and 120 provide signal component S'$_M$ in addition to noise signal component N'$_M$. This can occur if within extractors 117 and 120, frequency splitting as reflected in Figure 10 is realized, since an error in noise signal N'$_M$ cannot be excluded with certainty. An error can particularly occur if several adaptive filters are used, such as are found in sound reproduction media in the monitoring area.

Although any type of all-pass filter may be used, Figures 11 and 12 present typical embodiments of an all-pass filter of the first order. These filters typically have a reduced implementation cost. In the all-pass filter depicted in Figure 11, an input signal i(n) is fed to one coefficient element 124 having a coefficient $\lambda_1$ and also to a delay element 125 having a transfer function $Z^{-1}$. The outputs of coefficient element 124 and delay element 125 are connected to the inputs of an analog adder 126. An output of analog adder 126 is the all pass filter output signal o(n). The output signal o(n) is then input through delay element 127 having a transfer function $z^{-1}$ to coefficient element 128 also having a coefficient $\lambda_1$. The output of coefficient element $\lambda_1$ is input to analog adder 126.

In the all-pass filter shown in Figure 12, the input signal i(n) is input to an analog adder 129 and to analog adder 130. The output of analog adder 129 is input to analog adder 130 via a coefficient element 131 having a coefficient $\lambda_2$. The output of analog adder 130 is inverted by inverter 132 and input to delay element 133. The output of delay element 133 is input to analog adder 129 and analog adder 134. The output of coefficient element 131 is input to analog adder 134. Output signal o(n) can be tapped at the output of analog adder 134.

The all-pass filter of Figure 12 can be cascaded to all-pass filters of a higher order by inserting additional identical stages rather than inverter 132. Rather than the all-pass filters as shown, any other form of all-pass filters can be used as well as other filter elements, such as Laguere filters.

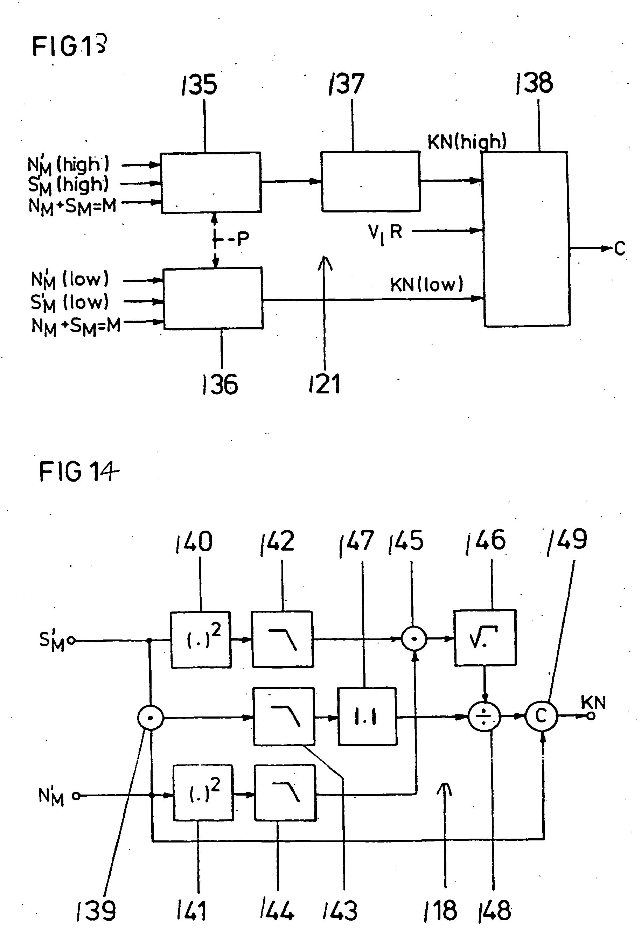

Figure 13 shows an example of control device 121 of Figure 9. Control device 121 of Figure 13 includes two corrective stages 135 and 136 to which are fed respective extracted signal components N'$_M$(high) and N'$_M$(low) and respective extracted desired signal components S'$_M$(high) and S'$_M$(low). The sum of noise signal N$_M$ and desired signal S$_M$ may optionally be input to corrective stages 135 and 126. The output signal from corrective stage 136 defines a corrected desired signal KN(low)) for low frequencies and is input to a signal generator 138; the output signal from corrective stage 135 is input to signal generator 138 via a selectively activated voice recognition unit 137 which outputs a corrected noise signal KN(high) for high frequency components. Control signal C is generated from the above inputs. The corrective stages 135, 136 limit residual errors contained in extracted noise signal component $N'_M$. In addition voice recognition unit 137 processes the output signal of corrective stage 135 to remove effects of voice energy on control signal C. Corrective stages 135, 136 may also adjust amplifier volume setting P. Control signal generator 118 of Figure 8 may optionally receive data on vehicle speed V, amplifier volume setting P, engine speed (RPM), etc.

Figure 14 shows an example of control device 118 of Figure 8. Control device 118 includes a multiplier 139 which receives extracted desired signal component $S'_M$ and extracted noise signal component $N'_M$. The extracted desired signal component $S'_M$ also is input to a squaring element 140, and the extracted noise signal component $N'_M$ also is input to a squaring element 141. Mean value generators 142, 143, 144, which may be all-pass filters, receive input signals from multiplier 139 and both squaring elements 140 and 141. The outputs of mean value generators 142 and 144 are input to a multiplier 145 which outputs a signal to an element 146 to extract a square root of its input signal. The outputs of element 146 and an absolute value element 147, which receives the output from mean value generator 143, are input to a divider 148. A controllable coefficient element 149, controlled by the extracted noise signal component $N'_M$ receives the output from divider 148. Corrected noise signal KN is then output from coefficient element 149.

An associated cross-correlation coefficient CCC of two signals X, Y is calculated as following:

$$CCC \; = \; \frac{|\, \Sigma\, (x-mean\,(x)) \cdot (y-mean\,(y))\, |}{\sqrt{\Sigma\, (x-mean\,(x))^2 \cdot (y-mean\,(y))^2}}$$

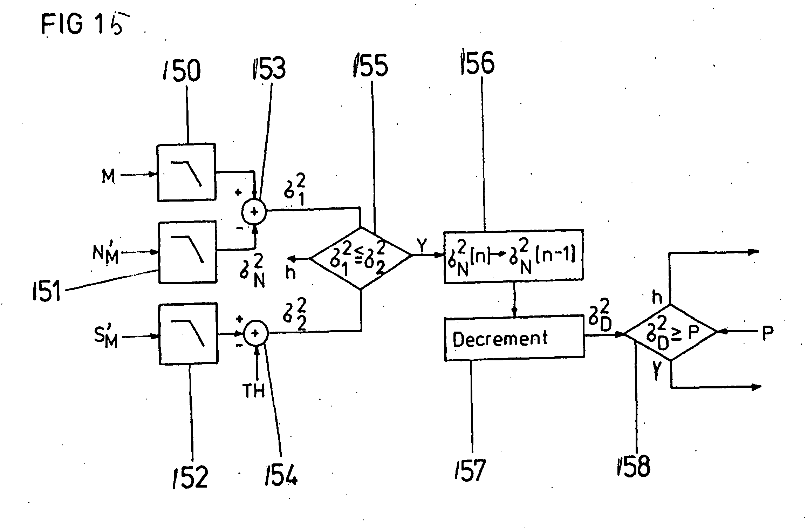

Another example is shown in Figure 15. Microphone signal M, the extracted noise signal $N'_M$ and extracted desired signal $S'_M$ are each fed to respective mean value generators 150, 151, 152. The output signals of mean value generators 150 and 151 are subtracted from each other at subtractor 153; defining a signal $\sigma_1^2$ at the output of subtractor 153. The output signal of mean value generator 152 is input to a subtractor 154 which subtracts from it the signal threshold value TH, forming signal $\sigma_2^2$. In downstream comparing stage 155, signals $\sigma^2_1$ and $\sigma^2_2$ are compared with one another. If $\sigma^2_{1 \leq} \sigma^2_2$, then the signals $\sigma_N^2$ at the output of mean value 151 is delayed by one value in delay stage 156. The delayed signal $\sigma^2_N$ is decremented at decrementing stage 157 and input as signal $\sigma_D^2$ to a discriminator stage 158 which compares signal $\sigma_D^2$ to signal P which represent the amplifier volume setting. If the signal $\sigma_D^2$ is larger than or equal to signal P, then the signal $\sigma_D^2$ is output, otherwise $\sigma_D^2$ is set equal to P.

If the signal $\sigma_N^2$ is primarily determined by environmental sounds, the discriminator 155 does not advance to the yes branch Y. The result is that the error in extracted noise signal $N'_M$ is minimal, and, the extracted noise signal $N'_M$ can be used for the generation of control signal C. Problems only occur if signal $\sigma_N^2$ is primarily determined by components of processed desired signal $S_L$ not calculable by the adaptive filter. In this case, the discriminator 155 supplies a positive response and the yes branch Y is followed.

The last detected sound level input into a mean value generator in the event of yes branching Y. Using the coefficient decrement; the mean value generator is slowly regulated downward by the time constant $\tau$ until the minimal amplifier volume value P set by the operator is reached or until the noise level in signal $\sigma^2_N$ increases so that the discriminator 155 advances to the no branch n.

Voice activity detection can be achieved by various means. Perhaps the simplest, but yet quite effective approach to implementing voice activity detection is by comparing short and long-duration energy. This concept, described in "Digital Signal Processing of Speech Signals" by L.R. Rabiner/R.W. Schafer, Prentice Hall (1978), can illustratively be used in implementing a voice activity detection unit, such as voice recognition unit 137. This concept can be described as follows. Speech is a pulse signal that contains a high level of energy over the short-term, but over an extended period of time possesses only a low amount of energy.

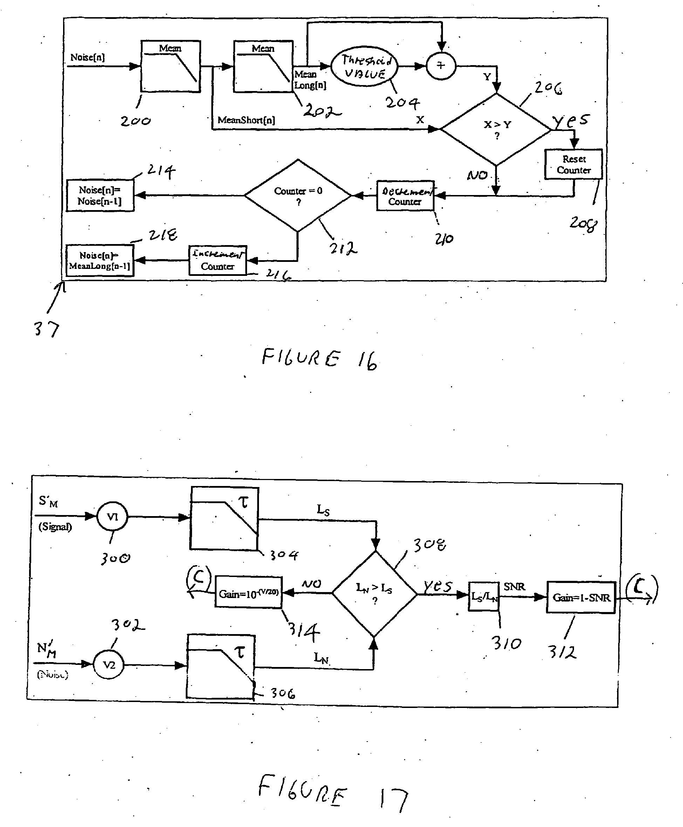

Referring to Figure 16, a noise signal n that may be contaminated with speech is picked up in a vehicle and from this noise signal n, short duration energy level X is generated at mean block 200 and long duration energy level is generated at mean block 202. Blocks 200, 202 can illustratively be value averagers. The long duration energy level then, to provide a safety margin, is raised by a threshold value at block 204, resulting in raised long duration energy level Y. Short duration energy level X and raised long duration energy level Y are then compared with each other at block 206 that, with the adept selection of the applicable time constants, allows for the determination of whether speech is present. If the short duration energy level X is greater than the raised long duration energy level Y, a counter is reset at block 208 and then decremented at block 210. If the short duration energy level X is not greater than the raised long duration energy level Y, the counter is decremented at block 210. At block 212, the counter is checked to see if it is zero and if it is, the noise signal n is set to the noise signal n-1 at block 214. If the counter is not zero, it is incremented at block 216 and the noise signal n set equal to the long duration energy level n-1 at block 218. In this regard, if speech is detected, the most recent long-duration level, which has not yet been affected (or at least not strongly affected) by the speech energy and will be passed on for a certain period as output value n. This time period can be set externally and, as soon as speech is detected, is automatically reset, irrespective of whether the counter has already run its process or is still in process.

There are many different ways of implementing control devices 6, 8, 118 and 121 (Figures 1, 2, 8 and 9, respectively), some of which have been described above.

The implementation of the control devices 6, 8, 118, 121 depends mainly on what is to be controlled, and at the same time, on the control signal C being determined reliably. That is, the "gain chase scenario," or positive feedback is avoided. The simplest way to determine a stable control signal is to determine the control signal C from the signal-to-noise ratio (SNR). In so doing, it is irrelevant whether this determination is made in the linear, logarithmic, or other domain.

Figure 17 is a block diagram showing a simple method of determining the signal-to-noise ratio in the linear domain which is then used as the control signal C. The extracted desired signal $S'_M$ and the extracted noise signal $N'_M$, produced by any of extractors 5 (Figure 1), 7, (Figure 2), 117 (Figure 8) or 120 (Figure 9) are scaled by scalers 300, 302 having weighting factors V1, V2, respectively. The outputs of scalers 300, 302 are processed through level meters 304, 306 to generate signals $L_s$ (representative of the level of the desired signal $S'_M$) and $L_N$ (representative of the level of the extracted noise signal $N'_M$). The level $L_N$ is then compared to the level $L_s$ at block 308. Control occurs only if the level $L_N$ is greater than the level $L_s$ in which event, the signal-to-noise ratio is calculated at 310 and the control signal C determined by subtracting the signal-to-noise ratio from one at block 312. If the level $L_s$ is greater than the level $L_N$, the noise is only of secondary importance and it is unnecessary to regulate control signal C in accordance with the signal-to-noise ratio.

Weighting factors V1, V2 effect a scaling that defines the maximum dynamics of regulation. In so doing, only a single factor, V1 or V2, must be modified according to the domain, but both can be modified. In this regard, the modification must be in decibels (dB) so that the "No" branch of block 308 functions correctly, and the correct control signal C is calculated at block 314. The gain value is, at the same time, selected so that a linear control process occurs, *i.e.,* the control action is without effect.

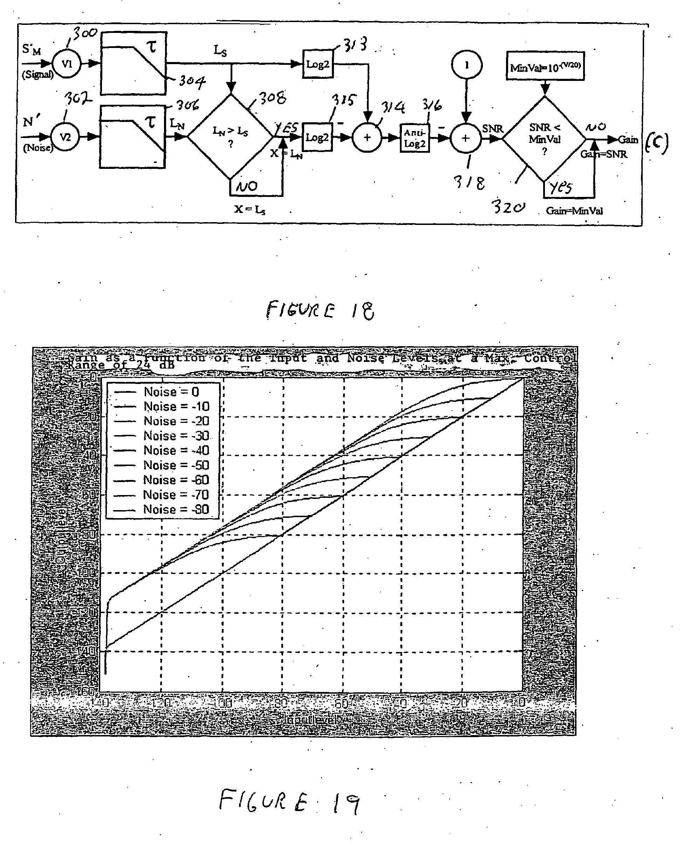

Figure 18 shows an implementation of the simple method just described in Figure 17, but in the logarithmic domain instead of the linear range. Like elements are identified with like reference designations. After $L_s$ and $L_N$ are generated and compared at comparison block 308, X is set equal to $L_N$ if $L_N$ is greater than $L_s$. Otherwise, X is set equal to $L_s$. The $Log_2$ of $L_s$ is taken at block 313 and the $Log_2$ of X is taken at block 315. The $Log_2$ value of X is subtracted from the $Log_2$ value of $L_s$ at summer 314 and the antilog$_2$ of the results taken at block 316. The signal-to-noise ratio output from block 318 and is then compared to a minimum value at block 320. If the signal-to-noise ratio is less than the minimum value, Gain (control signal C) is set equal to the minimum value. Otherwise, Gain (control signal C) is set equal to the signal-to-noise ratio.

Figure 19 is a graph showing Gain as a function of input level and noise at a maximum control range of 24 dB. As can be seen from Figure 19, the shape of the control curves remains constant and is only displaced up or down by the noise power $L_N$. By so doing, the shape is obtained so that, with increasing input level $L_s$), the output level (Gain) is successively reduced until it reaches a certain point automatically by the forming of the signal-to-noise ratio. From this point on, the output level (Gain) continues linearly up to the maximum volume, which is achieved by processing of the "No" branch for the linear implementation or by use of "MinVal" for the logarthmic implementation. This successive reduction of the output level (Gain) is necessary in order to avoid the "gain chase" scenario, *i.e.,* positive feedback. As a result, this prevents the occurrence of an independent "run-up" in volume (increase in output level) when the music is loud (high input levels).

The above described simple method of Figures 17 and 18 have certain weaknesses. These weaknesses include a relatively steep transition from the control range to the linear range, *i.e.,* an excessive compression ratio, which has a negative effect as the result of irregular volume follow-up. Also, the compression ratio that results from the signal-to-noise ratio is fixed and, as a result, cannot be adjusted. Further, the transition from the control range to the linear range, *i.e.*, the "break-point" in the control curve, is solely defined by the background noise, which also has an unpleasant effect on volume follow-up. Additionally, the direct use of the SNR value does not reflect the ideal and permits excessive fluctuation in the regulation. These weaknesses can be overcome by means of selective intervention in the algorithms used to determine the control signal C. For example, in the case of linear implementation of Figure 17, the compression ratio, *i.e.,* the transition from the control range to the linear range, can be softened or controlled by selectively introducing a mathematical function (e.g., an exponential function) into the signal flux, which could occur at a subsequent point.

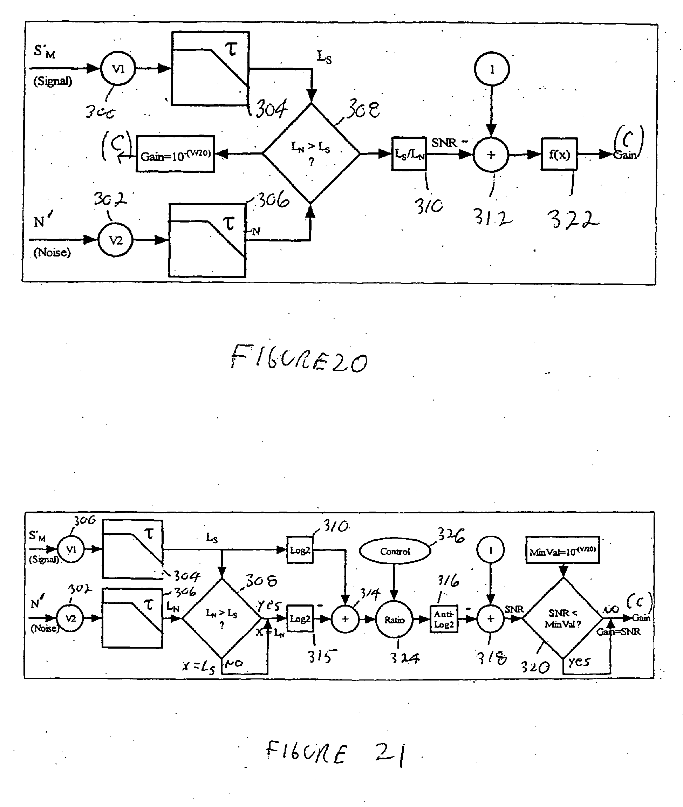

A modification to the linear domain method of Figure 17 to utilize such a mathematical function in this manner is shown in Figure 20. Like elements are identified with like reference designations and only the differences between the embodiment of Figure 20 and the embodiment of Figure 17 will be discussed. With reference to Figure 20, after the "Gain" is determined by block 312, it is modified by the function applied at block 322.

Figure 21 shows a modification to the logarithmic domain method of Figure 18. Like elements are identified with like reference designations and only the differences between the embodiment of Figure 21 and the embodiment of Figure 18 are discussed. An advantage that the logarithmic domain methods provide over the linear methods is that it is considerably easier to effect the control of the compression ratio. In the embodiments of Figures 18 and 21, this can be achieved by a single multiplication. In the embodiment of Figure 21, a ratio block 324, controlled by a control block 326, is inserted between summer 314 and antilog$_2$ block 316.

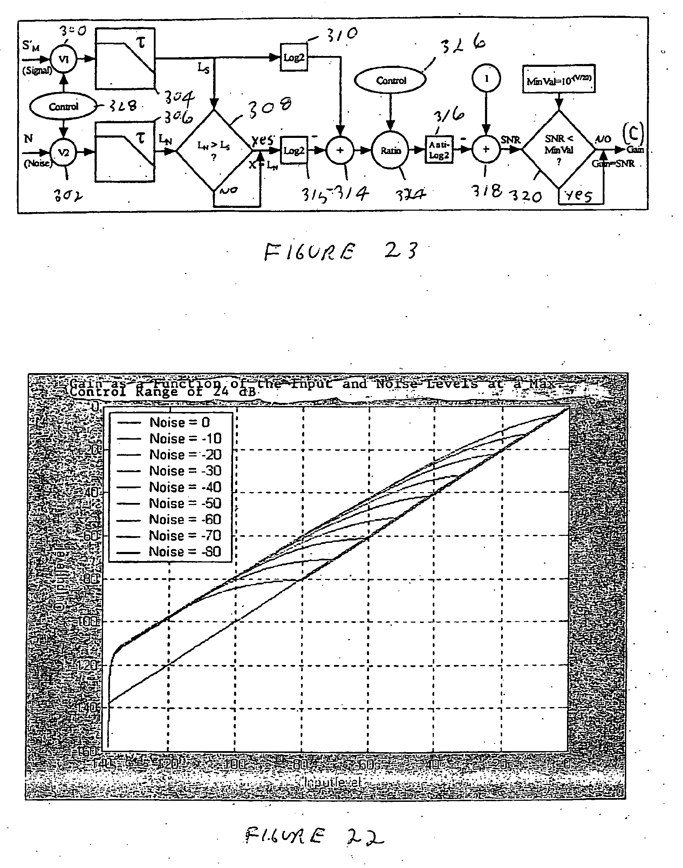

Figure 22 is a graph of the dynamic relations of the embodiment of Figure 21 in which the multiplication factor "ratio" is controlled externally as a function of the input level, again showing Gain as a function of the input and noise levels at a maximum control range of 24 dB. It should be noted, however, that control of the multiplication factor "ratio," which defines the resulting compression ratio, is dependent on a specific function, such as the input level. However, the noise level or a combination of noise and input levels could also be used via a function for generating the desired "ratio" value. It would also be feasible to modify the "ratio" value externally, as a function of a different parameter, such as volume, speed, etc. This, however, is decided individually on a case-by-case basis.

The modifications to the embodiments of Figures 17 and 18 shown in the embodiments of Figures 20 and 21 eliminate some of the above discussed weaknesses exhibited by the embodiments of Figures 17 and 18. Additional modifications can eliminate more of these weaknesses. For example, an input level-related sound volume range could be effective for the dynamic relations.

Figure 23 shows a modification to the embodiment of Figure 21 that provides additional control of the control range. Like elements are identified with like reference designations. In this regard, the embodiment of Figure 23 differs from the embodiment of Figure 21 only by the addition of a control block 328 that is coupled to scalers 300, 302. This embodiment enables scalers V1 and V2 to be modified.

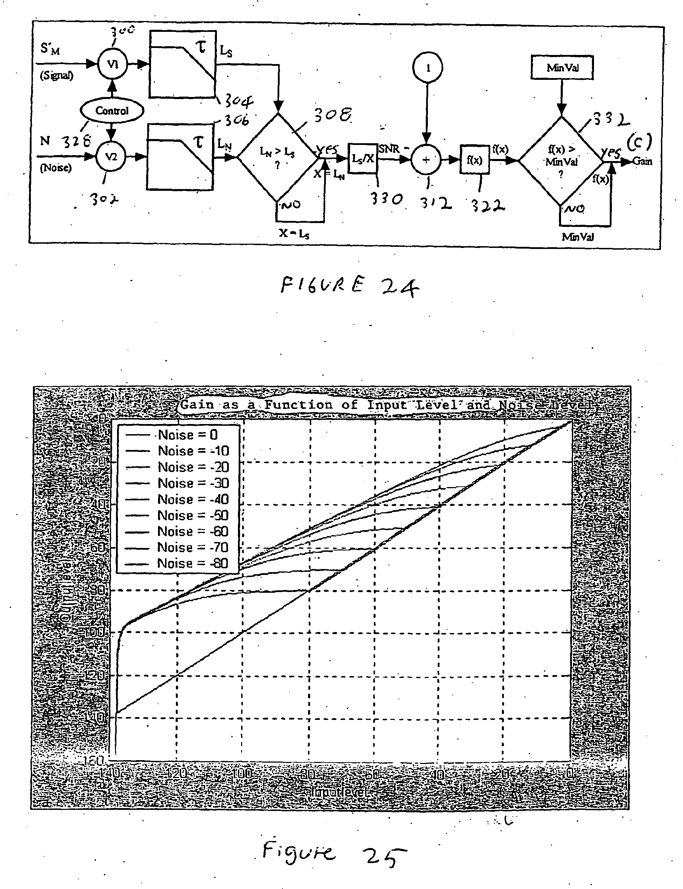

Figure 24 shows a modification to the embodiments of Figure 20 that provides additional control of the control range. Like elements are identified with like reference designations. The embodiment of Figure 24 also includes control block 328 that is coupled to scalers 300, 302. At comparison block 308, if $L_N$ is greater than $L_s$, X is set equal to $L_N$. Otherwise, X is set equal to $L_s$. At block 330, the signal-to-noise ratio is calculated by $L_s$ / X. After the function is applied to the "Gain" at block 322, the result is compared to a minimum value at comparison block 332. If the result is greater than the minimum value, the Gain, control signal C, is set equal to the result. Otherwise, the Gain is set equal to the minimum value.

In the embodiments of Figures 23 and 24, control of the control range can again be a function of various factors, such as volume, speed, etc., or a combination of them. Preferably, however, control of the control range should occur as a function of input level, since the control range requirements are greater for low input levels than for high input levels as low input levels are masked by low noise levels.

Figure 25 is a graph of the dynamic relations of the embodiment of Figure 23 wherein the control range is controlled externally as a function, such as of the input level. It should be understood that additional modifications are also feasible, such as nonlinear volume follow-up by control of the noise or output level, etc. The problem with such additional modifications is, of course, that they increase cost. In this regard, implementation in the logarithmic domain is easier to implement and if stability of volume regulation is of prime importance, then use of the signal-to-ratio for control of the Gain, *i.e.,* as the control signal C, is desirable.

The embodiments of Figures 17-25 show the extent to which regulation has an effect on the dynamic relations of the system. In this regard, these embodiments of generating the control signal C, that is, the implementation of control devices 6 (Figure 1), 8 (Figure 2), 118 (Figure 8) and 121 (Figure 9); approximate, more and more, a controlled dynamic controller that is, a controlled compressor. A "compressor" as would be understood by one skilled in the art, is a device which amplifies a signal's weak components and attenuates its strong components. Such a dynamic controller must be stably controlled, preferably by a single appropriate control signal, although more than one control signal can be used, and it also must provide all dynamic controller functionalities. A preferable implementation is to use a compressor for such a dynamic controller since a compressor already possesses the required basic functionality to raise soft input signals, that is, to be able to control the volume. Ideally, a pure noise signal would be used to control the compressor. However, as has been discussed, the noise signal that can be economically developed is not a pure noise signal. Thus, the "gain chase" scenario results.

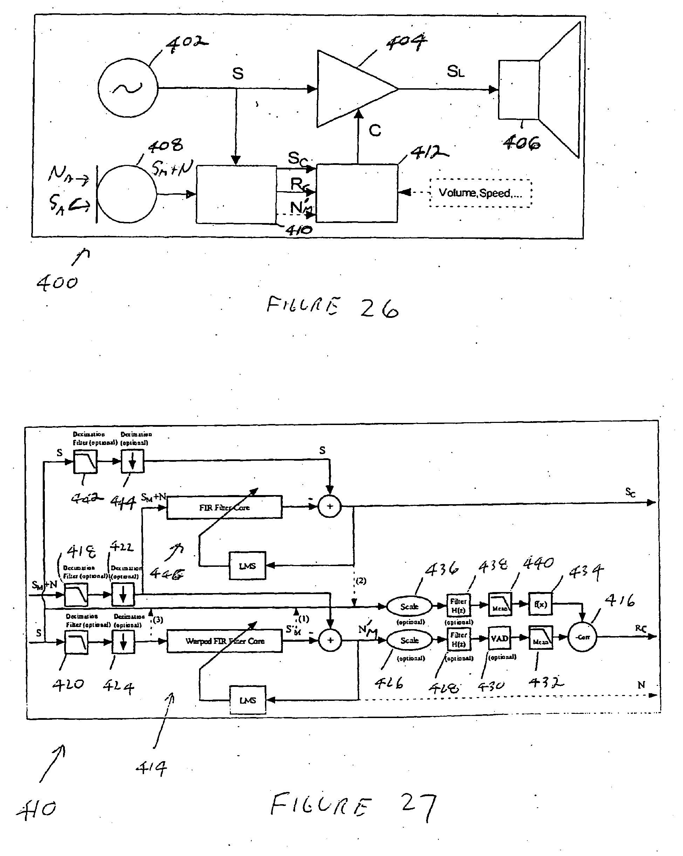

Figure 26 is a simplified block diagram of an exemplary device 400 for dynamic sound optimization that utilizes a dynamic controller and is helpful for understanding more completely the advantages of the present invention. Device 400 comprises a signal source 402, such as a CD player, a MP3 player, a radio receiver, or an audio cassette player. The signal source 402 outputs an electrical sound signal S to a variable gain amplifier 404. A control signal C varies the gain of the variable gain amplifier 404 to produce a processed source signal $S_L$ that drives speaker 406.

A microphone 408 monitors the sound within the listening environment and generates an electrical monitoring signal $S_M$+N which includes an ambient noise signal N and audio sound signal $S_M$. Audio sound signal $S_M$ matches the signal that is output by speaker 406 as convoluted with the spatial impulse response. In other words, $S_M$ represents the output from speaker 406 as affected by the listening environment. The monitoring or microphone signal $S_M$+N and electrical sound signal S are applied to a processing block 410 which generates an input signal $S_C$ and a control signal

$R_C$ that are fed to dynamic controller 412. Dynamic controller 412, which is preferably a compressor, generates control signal C. An extracted noise signal $N'_M$ derived by processing block 410 from monitoring signal $S_M + N$ and source signal S may optionally also be fed to dynamic controller 412, as can additional control parameters such as volume, speed, etc., as shown by the dashed lines. However, the extracted noise signal $N'_M$ that is optionally fed to dynamic controller 412 from processing block 410 is not used to control dynamic controller 412, but for other things such as noise level-related equalizing. Variable gain amplifier 404, processing block 410 and dynamic controller 412 can, illustratively, be implemented digitally, such as in software in one or more signal processors or microprocessors.

Figure 27 shows in more detail processing block 410. Processing block 410 develops the control signal $R_C$ by extracting the extracted noise signal $N'_M$ by applying the source signal S and the microphone signal $S_M + N$ to a warped adaptive filter 414 (such as has been described previously), determining a correction factor CORR from the source signal S and applying the correction factor CORR to the extracted noise signal $N'_M$ by multiplying the extracted noise signal $N'_M$ by the correction factor CORR with multiplier 416. The tap weights of the warped adaptive filter 414 are set in accordance with the least mean squares (LMS) method which is determined in accordance with the extracted noise signal $N'_M$. The source signal S and the microphone signal $S_M + N$ are downsampled before being applied to warped adaptive filter 414. That is, the source signal S and the microphone signal $S_M + N$ are input to respective decimation filters 418, 420 (which are anti-aliasing filters), and the outputs of decimation filters 418, 420 input to respective decimation stages 422, 424. Before the correction factor CORR is applied to the extracted noise signal $N'_M$ at multiplier 416 to generate control signal $R_C$, the extracted noise signal $N'_M$ is processed by scaler 426, high pass filter 428, voice activity detection block 430 and mean block 432.

Processing block 410 develops the correction factor CORR by using the source signal S as an input to a transfer function block 434. Before source signal S is input to transfer function block 434, it is processed by scaler 436, high pass filter 438 and mean block 440.

Scalers 426, 436 are used to normalize the source signal S and the extracted noise signal $N'_M$ onto the same scale on an amplitude and energy basis. High pass filter 428 takes into account the psychoacoustic aspects of the noise in the vehicle. In vehicles, low and sub-audio frequencies are more heavily weighted (have higher energy content) than higher audio frequencies and should-be attenuated or filtered to obtain better control characteristics. High pass filter 438 provides analogous filtering to the processed source signal S. Voice activity detection block 430 eliminates interfering voice signals from the extracted noise signal $N'_M$ so that the system reacts to "true" interference noise, such as fan, wind, road or engine noise, and not to voices.

Processing block 410 generates the input signal $S_c$ for the compressor that is preferably dynamic controller 412 by applying source signal S, after it has been downsampled by decimation filter 442 and decimation stage 444, and the downsampled microphone signal $S_M + N$ to an adaptive filter 446. Adaptive filter 446 is preferably a short finite impulse response (FIR) filter with its tap weights set in accordance with the LMS method which is determined in accordance with the output signal $S_c$. In this regard, adaptive filter 446 functions as a system inverter to remove sound components introduced by the listening environment. In particular, adaptive filter 446 corrects at least in part for wind noise.

It should be understood that decimation filters 418, 420, 442, decimation stages 422, 424, 444, while preferred, are optional. Also, while preferred, scalers 426, 436, filters 428, 438 and voice activity detection block 430 are also optional.

In this regard, if downsampling is not used or only a very moderate downsampling is used, the signals indicated by the dashed-line paths (1), (2) and (3) in Figure 27 can be used. Doing so would assure that the respective signals $S'_M$, Sc, as well as the decimated version of S, contain all or most of the signal components of the original source signal S. This is important for the correct generation of the control signal $R_C$. If a certain amount of error can be tolerated, the above signals shown by the dashed-line paths (1), (2) and (3) can be used even for larger decimations, although it is not desirable to do so. Use of pure signals is preferred.

A weakness exhibited by the embodiment of device 400 shown in Figures 26 and 27 is that it does not take into account the energy of the momentarily radiated, regulated music signal. The processed source signal $S_L$ contains this information and can be used advantageously in developing the control signal $R_C$.

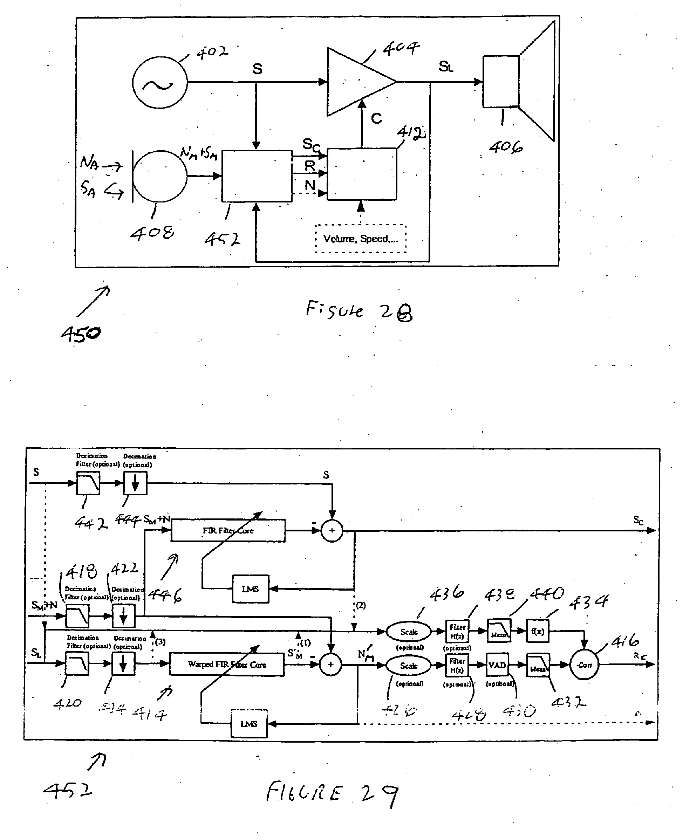

Figure 28 shows a modification of device 400 to utilize the processed desired source signal $S_L$ to develop the control signal $R_C$. Like elements will be identified with the like reference designations and only the differences between device 450 of Figure 28 and device 400 of Figure 26 will be discussed. In device 450, processing block 410 is replaced with processing block 452 to which processed source signal $S_L$ is fed.

Figure 29 shows an example of processing block 452 of Figure 28, with the dashed lines again showing alternate signal paths. Processing block 452 is similar in many respects to processing block 410 shown in Figure 27. Like elements will be identified with like reference designations and only the differences between devices 452 and 410 will be discussed. In this regard, the principal difference between devices 452 and 410 is that the processed source signal $S_L$ is input to adaptive warped filter 414 through decimation filter 420 and decimation stage 424 as opposed to source signal S. Processed source signal $S_L$ contains information on the momentary energy content of the regulated source signal S, which is important for the correct generation of the control signal $R_C$.

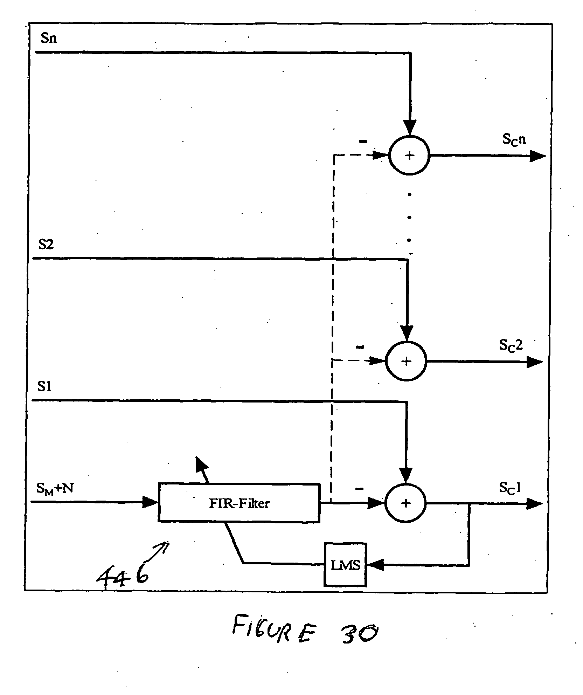

Since there are typically a plurality of source signals ($S_C1$ thru $S_Cn$) present (e.g., left and right stereo channel stereo signals), input signals ($S_C1$ thru $S_Cn$) are generated in the same fashion for each source signal $S_C$. In this regard, as shown in Figure 30, each input signal $S_C$ can be developed from a single adaptive filter 446, as shown in dashed-lines in Figure 30, or multiple adaptive filters 446, that is, one adaptive filter for each input signal $S_C$. Using one adaptive filter 446 as opposed to multiple adaptive filters 446, while introducing a certain amount of error, results in a system that is less costly to implement as only one adaptive filter 446 need be implemented.

The basic approach used by devices 400 and 450 in controlling volume is to do so based on ambient noise. They preferably do so by using a compressor for dynamic controller 412 and using the ambient noise to control the compressor ratio, with the output of the compressor being the control signal C that controls the gain of variable gain amplifier 404. However, as has been discussed, the extracted noise signal $N'_M$ is error laden due to the finite length of the adaptive warped filter 414 that generates it. Consequently, it is not a "pure" ambient noise signal that contains only the noise component of the microphone signal $S_M + N$. Rather, it also includes some of the audio sound signal component $S_M$ of the microphone signal $S_M + N$. Thus, if only the extracted noise signal $N'_M$ was used to control the compressor ratio $R_C$, the "gain chase" scenario would result because increases in the sound output by speaker 406 would cause an increase in the extracted noise signal $N'_M$. Therefore, devices 400, 450 correct the extracted noise signal $N'_M$ by applying correction factor CORR. Correction factor CORR limits the minimum slope of the compressor curve (maximum compressor ratio) as a function of the level of the source signal S.

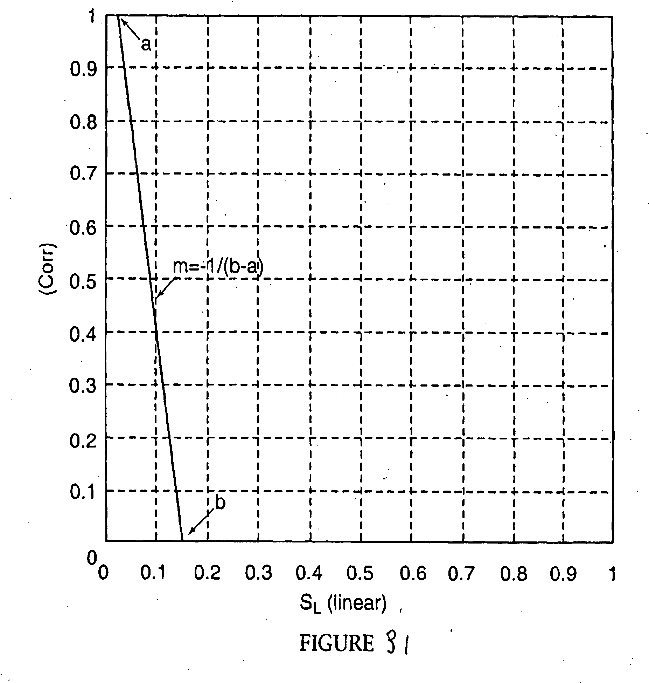

Figure 31 is typical of the type of transfer function f(x) of transfer function block 434 of Figure 29 that determines the correction factor CORR from the processed source signal $S_L$. A similar type of transfer function can illustratively used for the transfer function of transfer function block 434 of Figure 27. As can be seen from Figure 31, the correction factor CORR varies from one when the level of processed source signal $S_L$ is less-than a minimum level to zero when the level of the processed source signal $S_L$ exceeds a maximum level. The effect of applying correction factor CORR to the extracted noise signal $N'_M$ is that device 450 is "deactivated" (in the sense that no dynamic volume control occurs) when the level of the processed source signal $S_L$ exceeds the maximum level, controls volume based on the extracted noise signal $N'_M$ when the level of the processed source signal $S_L$ is less than the minimum level, and controls volume based on a reduced extracted noise signal $N'_M$, that is, $N'_M$ multiplied by the correction factor (CORR), when the level of the processed source signal $S_L$ is between the minimum and maximum levels.

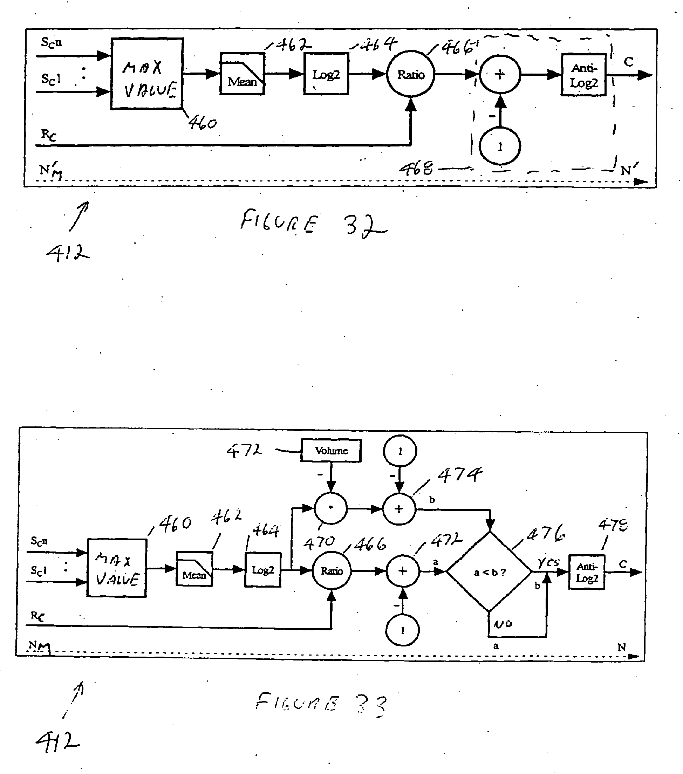

Figure 32 shows in simplified form the compressor that can illustratively be used as dynamic controller 412. The input signals ($S_C1$ thru $S_Cn$) are processed through maximum value block 460 that determines which of the input signals $S_C$ have the greatest value and passes that input signal $S_C$ to mean block 462. Mean block 462 determines the mean of that input signal $S_C$ and a corresponding logarithmic signal is generated by $\text{Log}_2$ block 464. The $\text{Log}_2$ signal is then multiplied by the control signal $R_C$ at multiplier 466. Multiplier 466 is designated as "Ratio" in Figure 32 because the effect of multiplying the logarithmic signal generated by Log2 block 464 by the control signal $R_C$ is to set the ratio of the compressor that is dynamic controller 412. The output of multiplier 466 is then converted to a linear signal by antilog block 468, this linear signal constituting the control signals C that controls the gain of variable gain amplifier 404.

Figure 33 shows a modification to the compressor of Figure 32 to utilize the optional control parameters, such as a speed related control signal (Speed) or a volume control signal (Volume) such as would be provided by a user adjusting a volume control. For example, if it is desired to increase the volume impression by using the compressor that is preferably used as dynamic controller 412, the Volume control signal must be used as the noise-related control of the compressor occurs only within a limited range of processed source signal $S_L$ so as to preclude gain chase. In so doing, the compressor is then appropriately activated only when one comes close to full scale. Like elements in the embodiments of Figures 32 and 33 are identified with like reference designations and only the differences between the embodiments of Figures 32 and 33 will be discussed. The output of $\text{log}_2$ block 464 is fed to multiplier 470 where it is multiplied by a Volume control signal generated by volume control device 472. The output of multiplier 466 and the output of multiplier 470, after processing through respective summers 472, 474, to generate respective signals (a) and (b), are compared at comparison block 476. If (a) is less than (b), (b) is processed through $\text{antilog}_2$ block 478 to generate a linear signal used as control signal, C. Otherwise, (a) is processed through $\text{antiog}_2$ block 478 to generate control signal C.

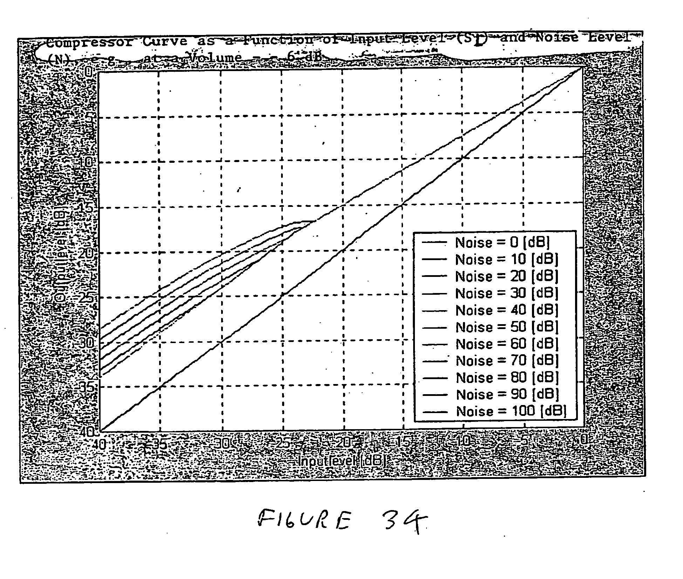

Figure 34 shows the performance of device 450 in which the dynamic controller 412 shown in Figure 33 is used. The effect of a change in the Volume control signal can be seen from Figure 34. It should be understood that with the use of the noise related control signal $R_C$ and the Volume control signal, it is the larger of the two that is used to generate the control signal C that controls the volume of variable gain amplifier 404.

The description of the invention is merely exemplary in nature and, thus, variations that do not depart from the gist of the invention are intended to be within the scope of the invention. Such variations are not to be regarded as a departure from the scope of the invention.

**Claims**

**1.** A device for the noise-dependent adjustment of a sound output radiated by a sound transducer (3) in an environment, said device comprising:

a signal source (1) providing a desired electrical signal (S);

a regulating apparatus (2) to which said desired electrical signal (S) is provided that produces a processed desired signal ($S_L$) therefrom, said processed desired signal ($S_L$) provided to said sound transducer (3) that produces said sound output therefrom;

a sound pickup (4) detecting sound in said environment that includes a sound output component related to said sound output and an acoustic noise component, the sound pickup (4) providing a monitoring signal (M) that includes a monitored sound component corresponding to said sound output component and a monitored noise component corresponding to said acoustic noise components

a controller (6) generating a control signal (C) that is provided to said regulating apparatus (2);

said sound regulating apparatus (2) varying said processed desired electrical signal ($S_L$) in response to said control signal (C);

**characterized by**

an extractor (5) to which said monitoring signal (M) is provided, said extractor (5) generating at least an extracted noise signal ($N'_M$) representative of said monitored noise component of said monitoring signal (M) and an extracted sound output component signal ($S'_M$) representative of said monitored sound output component and provides the extracted sound output component signal ($S'_M$) to the controller (6);

**and In that**

the controller (6) generates the control signal from the extracted noise signal ($N'_M$) and the extracted sound output component signal ($S'_M$).

2.  The device according to claim 1, wherein said controller (6) generates said control signal (C) based on a signal-to-noise ratio defined as a ratio of said extracted sound output component signal ($S'_M$) to said extracted noise signal ($N'_M$).

3.  The device according to claim 1, wherein said controller (6) generates said control signal (C) based on a signal-to-noise ratio defined as a ratio of said extracted sound output component signal ($S'_M$) to said extracted noise signal ($N'_M$), when said extracted noise signal is greater than said extracted sound output component signal.

4.  The device according to claim 1, wherein the controller (6) generates the control signal based on the monitoring signal (M).

5.  The device according to claim 1, wherein, at least one state signal corresponding to at least one of a volume setting, an engine RPM, and a vehicle speed is provided to said controller (6) and is used by said controller (6) in generating said control signal (C).

6.  The device according to claim 1, wherein said processed desired signal ($S_L$) is provided to an input of said extractor (5).

7.  The device according to claim 1, wherein said desired electrical signal (S) is provided to an input of said extractor (5).

8.  The device according to claim 1, wherein said extractor (5) further comprises at least one adaptive filter.

9.  A method for the noise-dependent adjustment of a sound output radiated by a sound transducer (3) in an environment, said method comprising the steps of:

generating a desired electrical signal (S);

generating a processed desired electrical signal ($S_L$) from said desired electrical signal (S);

said sound transducer (3) producing said sound output from said processed desired electrical signal ($S_L$);

monitoring sound in said environment and generating a monitoring signal (M) therefrom that includes a sound output component related to said sound output and an acoustic noise component;

extracting from said monitoring signal (M) at least an extracted noise signal ($N'_M$) related to said acoustic noise component and an extracted sound output component signal ($S'_M$) related to said sound output component;

generating a control signal (C) from said extracted noise signal ($N'_M$) and from the extracted sound output component signal ($S'_M$);

and varying said processed desired electrical signal ($S_L$) in response to said control signal (C).

10. The method according to claim 9, wherein the control signal (C) is also generated from said monitoring signal (M).

**EP 1 275 200 B1**

11. The method according to claim 9, further including the step of extracting from said monitoring signal (M) an extracted sound output component signal ($S'_M$) related to said sound output component, and wherein the step of generating said control signal (C) comprises generating said control signal (C) based on a signal-to-noise ratio defined as a ratio of said extracted sound output component signal ($S'_M$) and said extracted noise signal ($N'_M$).

12. The method according to claim 9, further including the step of extracting from said monitoring signal (M) an extracted sound output component signal ($S'_M$) related to said sound output component, and wherein the step of generating said control signal (C) comprises generating said control signal (C) based on a signal-to-noise ratio defined as a ratio of said extracted sound output component signal ($S'_M$) and said extracted noise signal ($N'_M$), when said extracted noise signal is greater than said extracted sound component signal.

13. An audio system having dynamic sound optimization, comprising:

   a signal source (1) providing a desired electrical signal (S);
   a regulating apparatus (2) to which said desired electrical signal (S) is provided that generates a processed desired electrical signal ($S_L$) therefrom;
   a sound transducer (3) to which said processed desired electrical signal ($S_L$) is provided that generates a sound output therefrom that is radiated in an environment;
   a sound pickup (4) detecting sound in said environment that includes a component related to said sound output and an acoustic noise component, the sound pickup (4) providing a monitoring signal (M) that includes a monitored sound component corresponding to said sound output component and a monitored noise component corresponding to said acoustic noise component;
   an extractor (5) to which said monitoring signal (M) is provided, said extractor (5) generating at least an extracted noise signal ($N'_M$) representative of said monitored noise component of said monitoring signal (M) and an extracted sound output signal ($S'_M$) representative of said monitored sound output component; and
   a controller (6) to which said extracted noise signal and said extracted sound output signal ($S'_M$) are provided, said controller (6) generating a control signal (C) in response to said extracted noise signal ($N'_M$) and said extracted sound output signal ($S'_M$), said control signal (C) provided to said regulating apparatus (2), said sound regulating apparatus (2) varying said processed desired electrical signal ($S_L$) in response to said control signal (C).

14. The system according to claim 13, wherein said controller (6) generates said control signal (C) based on a signal-to-noise ratio defined as a ratio of said extracted sound output signal ($S'_M$) to said extracted noise signal ($N'_M$).

15. The system according to claim 13, wherein said controller (6) generates said control signal (C) based on a signal-to-noise ratio defined as a ratio of said extracted sound output signal ($S'_M$) to said extracted noise signal ($N'_M$) when said extracted noise signal is greater than said extracted sound output signal.

16. The system according to claim 13, and further including a voice activity detector that removes, at least in part, an effect of voice in the environment from said extracted noise signal prior to said extracted noise signal being used by said controller (6) to generate said control signal (C).

**Patentansprüche**

1. Eine Vorrichtung für eine geräuschabhängige Anpassung einer Tonausgabe, die von einem Tonsignalwandler (3) in eine Umgebung abgestrahlt wird, wobei die genannte Vorrichtung umfasst:

   eine Signalquelle (1), die ein gewünschtes elektrisches Signal (S) bereitstellt;
   eine Regeleinrichtung (2), zu der das genannte gewünschte elektrische Signal (S) geliefert wird, die ein verarbeitetes gewünschtes Signal ($S_L$) daraus erzeugt, wobei das genannte verarbeitete gewünschte Signal ($S_L$) an den genannten Tonsignalwandler (3) geliefert wird, der die genannte Tonausgabe daraus erzeugt;
   eine Tonaufnahmeeinrichtung (4), die Schall in der genannten Umgebung detektiert, der eine Tonausgabekomponente, die zu der genannten Tonausgabe in Beziehung steht, und eine akustische Geräuschkomponente enthält, wobei die Tonaufnahmeeinrichtung (4) ein Überwachungssignal (M) bereitstellt, das eine überwachte Tonkomponente entsprechend der genannten Tonausgabekomponente und eine überwachte Geräuschkomponente entsprechend der genannten akustischen Geräuschkomponente enthält;
   ein Kontroller (6), der ein Steuersignal (C) erzeugt, das an die genannte Regeleinrichtung (2) geliefert wird;

wobei die genannte Regeleinrichtung (2) das genannte verarbeitete gewünschte elektrische Signal ($S_L$) in Reaktion auf das genannte Steuersignal (C) verändert;

**gekennzeichnet durch**

eine Extrahiereinrichtung (5), an die das genannte Überwachungssignal (M) geliefert wird, wobei die genannte Extrahiereinrichtung (5) zumindest ein extrahiertes Geräuschsignal ($N'_M$), das für die genannte überwachte Geräuschkomponente des genannten Überwachungssignals (M) repräsentativ ist, und ein extrahiertes Tonausgabekomponentensignal ($S'_M$), das für die genannte überwachte Tonausgabekomponente repräsentativ ist, erzeugt und das extrahierte Tonausgabekomponentensignal ($S'_M$) an den Kontroller (6) liefert;

und darin, dass

der Kontroller (6) das Steuersignal aus dem extrahierten Geräuschsignal ($N'_M$) und dem extrahierten Tonausgabekomponentensignal ($S'_M$) erzeugt.

2. Die Vorrichtung gemäß Anspruch 1, in der der genannte Kontroller (6) das genannte Steuersignal (C) auf der Grundlage eines Signal - zu - Rausch - Verhältnisses erzeugt, das als ein Verhältnis von dem genannten extrahierten Tonausgabekomponentensignal ($S'_M$) zu dem genannten extrahierten Geräuschsignal ($N'_M$) definiert ist.

3. Die Vorrichtung gemäß Anspruch 1, in der der genannte Kontroller (6) das genannte Steuersignal (C) auf der Grundlage eines Signal - zu - Rausch - Verhältnisses erzeugt, das als ein Verhältnis von dem genannten extrahierten Tonausgabekomponentensignal ($S'_M$) zu dem genannten extrahierten Geräuschsignal ($N'_M$) definiert ist, wenn das genannte extrahierte Geräuschsignal stärker als das genannte extrahierte Tonausgabekomponentensignal ist.

4. Die Vorrichtung gemäß Anspruch 1, in der der Kontroller (6) das Steuersignal auf der Grundlage des Überwachungssignals (M) erzeugt.

5. Die Vorrichtung gemäß Anspruch 1, in der zumindest ein Statussignal entsprechend zumindest eines von einer Lautstärkeeinstellung, einer Motordrehzahl und einer Fahrzeuggeschwindigkeit an den genannten Kontroller (6) geliefert wird und von dem genannten Kontroller (6) für die Erzeugung des genannten Steuersignals (C) verwendet wird.

6. Die Vorrichtung gemäß Anspruch 1, in der das genannte verarbeitete gewünschte Signal ($S_L$) an einen Eingang der genannten Extrahiereinrichtung (5) geliefert wird.

7. Die Vorrichtung gemäß Anspruch 1, in der das genannte gewünschte elektrische Signal (S) an einen Eingang der genannten Extrahiereinrichtung (5) geliefert wird.

8. Die Vorrichtung gemäß Anspruch 1, in der die genannte Extrahiereinrichtung (5) weiterhin zumindest einen adaptiven Filter umfasst.

9. Ein Verfahren für die geräuschabhängige Anpassung einer Tonausgabe, die von einem Tonsignalwandler (3) in eine Umgebung abgestrahlt wird, wobei das Verfahren die Schritte umfasst:

Erzeugen eines gewünschten elektrischen Signals (S);
Erzeugen eines verarbeiteten gewünschten elektrischen Signals ($S_L$) aus dem genannten gewünschten elektrischen Signal (S);
wobei der genannte Tonsignalwandler (3) die genannte Tonausgabe aus dem genannten verarbeiteten gewünschten elektrischen Signal ($S_L$) erzeugt;
Überwachen von Schall in der genannten Umgebung und Erzeugen eines Überwachungssignals (M) daraus, das eine Tonausgabekomponente, die mit der genannten Tonausgabe in Beziehung steht, und eine Komponente eines akustischen Geräuschs enthält;
Extrahieren von zumindest einem extrahierten Geräuschsignal ($N'_M$), das mit der genannten Komponente eines akustischen Geräuschs in Beziehung steht, und eines extrahierten Tonausgabekomponentensignals ($S'_M$), das mit der genannten Tonausgabekomponente in Beziehung steht, aus dem genannten Überwachungssignal (M);
Erzeugen eines Steuersignals (C) aus dem genannten extrahierten Geräuschsignal ($N'_M$) und aus dem extrahierten Tonausgabekomponentensignal ($S'_M$);
und Verändern des genannten verarbeiteten gewünschten elektrischen Signals ($S_L$) in Reaktion auf das genannte Steuersignal (C).

10. Das Verfahren gemäß Anspruch 9, in dem das Steuersignal (C) ebenso aus dem genannten Überwachungssignal (M) erzeugt wird.

**11.** Das Verfahren gemäß Anspruch 9, das weiterhin den Schritt des Extrahierens eines extrahierten Tonausgabekomponentensignals ($S'_M$), das mit der genannten Tonausgabekomponente in Beziehung steht, aus dem genannten Überwachungssignal (M) einschließt, und in dem der Schritt des Erzeugens des genannten Steuersignals (C) das Erzeugen des genannten Steuersignals (C) auf der Grundlage eines Signal - zu - Rausch - Verhältnisses umfasst, das als ein Verhältnis von dem genannten extrahierten Tonausgabekomponentensignal ($S'_M$) zu dem genannten extrahierten Geräuschsignal ($N'_M$) definiert ist.

**12.** Das Verfahren gemäß Anspruch 9, das weiterhin den Schritt des Extrahierens eines extrahierten Tonausgabekomponentensignals ($S'_M$), das mit der genannten Tonausgabekomponente in Beziehung steht, aus dem genannten Überwachungssignal (M) einschließt, und in dem der Schritt des Erzeugens des genannten Steuersignals (C) das Erzeugen des genannten Steuersignals (C) auf der Grundlage eines Signal - zu - Rausch - Verhältnisses, das als ein Verhältnis von dem genannten extrahierten Tonausgabekomponentensignal ($S'_M$) zu dem genannten extrahierten Geräuschsignal ($N'_M$) definiert ist, umfasst, wenn das genannte extrahierte Geräuschsignal stärker als das genannte extrahierte Tonkomponentensignal ist.

**13.** Ein Audiosystem, das eine dynamische Tonoptimierung aufweist, umfassend:

eine Signalquelle (1), die ein gewünschtes elektrisches Signal (S) bereitstellt; eine Regeleinrichtung (2), an die das genannte gewünschte elektrische Signal (S) geliefert wird, die ein verarbeitetes gewünschtes elektrisches Signal ($S_L$) daraus erzeugt;

einen Tonsignalwandler (3), an den das genannte verarbeitete gewünschte elektrische Signal ($S_L$) geliefert wird, der eine Tonausgabe daraus erzeugt, die in eine Umgebung abgestrahlt wird;

eine Tonaufnahmeeinrichtung (4), die Schall in der genannten Umgebung detektiert, der eine Komponente, die zu der genannten Tonausgabe in Beziehung steht, und eine akustische Geräuschkomponente enthält, wobei die Tonaufnahmeeinrichtung (4) ein Überwachungssignal (M) bereitstellt, das eine überwachte Tonkomponente entsprechend der genannten Tonausgabekomponente und eine überwachte Geräuschkomponente entsprechend der genannten akustischen Geräuschkomponente enthält;

eine Extrahiereinrichtung (5), an die das genannte Überwachungssignal (M) geliefert wird, wobei die genannte Extrahiereinrichtung (5) zumindest ein extrahiertes Geräuschsignal ($N'_M$), das für die genannte überwachte Geräuschkomponente des genannten Überwachungssignals (M) repräsentativ ist, und ein extrahiertes Tonausgabekomponentensignal ($S'_M$), das für die genannte überwachte Tonausgabekomponente repräsentativ ist, erzeugt; und

einen Kontroller (6), an den das genannte extrahierte Geräuschsignal und das genannte extrahierte Tonausgabesignal ($S'_M$) geliefert werden, wobei der genannte Kontroller (6) in Reaktion auf das genannte extrahierte Geräuschsignal ($N'_M$) und das genannte extrahierte Tonausgabesignal ($S'_M$) ein Steuersignal (C) erzeugt, wobei das genannte Steuersignal (C) an die genannte Regeleinrichtung (2) geliefert wird, wobei die genannte Tonregeleinrichtung (2) das genannte verarbeitete gewünschte elektrische Signal ($S_L$) in Reaktion auf das genannte Steuersignal (C) verändert.

**14.** Das System gemäß Anspruch 13, in dem der genannte Kontroller (6) das genannte Steuersignal (C) auf der Grundlage eines Signal - zu - Rausch - Verhältnisses, das als ein Verhältnis von dem genannten extrahierten Tonausgabekomponentensignal ($S'_M$) zu dem genannten extrahierten Geräuschsignal ($N'_M$) definiert ist, erzeugt.

**15.** Das System gemäß Anspruch 13, in dem der genannte Kontroller (6) das genannte Steuersignal (C) auf der Grundlage eines Signal - zu - Rausch - Verhältnisses erzeugt, das als ein Verhältnis von dem genannten extrahierten Tonausgabekomponentensignal ($S'_M$) zu dem genannten extrahierten Geräuschsignal ($N'_M$) definiert ist, wenn das genannte extrahierte Geräuschsignal stärker als das genannte extrahierte Tonausgabesignal ist.

**16.** Das System gemäß Anspruch 13 und weiterhin einen Stimmaktivitätsdetektor einschließend, der zumindest zum Teil einen Effekt einer Stimme in der Umgebung aus dem genannten extrahierten Geräuschsignal entfernt, bevor das genannte extrahierte Geräuschsignal von dem genannten Kontroller (6) dazu verwendet wird, das genannte Steuersignal (C) zu erzeugen.

**Revendications**

1. Dispositif de réglage en fonction du bruit d'une sortie de signal acoustique rayonnée par un transducteur acoustique (3) dans un environnement, ledit dispositif comprenant :

   une source de signal (1) fournissant un signal électrique souhaité (S),
   un dispositif de régulation (2) auquel ledit signal électrique souhaité (S) est fourni, qui produit un signal souhaité traité ($S_L$) à partir de celui-ci, ledit signal souhaité traité ($S_L$) étant fourni audit transducteur acoustique (3) qui produit à partir de celui-ci la sortie de signal acoustique,
   un élément d'acquisition de son (4) détectant un signal acoustique dans ledit environnement, qui comprend une composante de sortie de signal acoustique associée à ladite sortie de signal acoustique et une composante de bruit acoustique,
   l'élément d'acquisition de son (4) fournissant un signal de surveillance (M) qui comprend une composante de signal acoustique surveillée correspondant à ladite composante de sortie de signal acoustique et une composante de bruit surveillée correspondant à ladite composante de bruit acoustique,
   un contrôleur (6) générant un signal de commande (C) qui est fourni audit dispositif de régulation (2),
   ledit dispositif de régulation de son (2) faisant varier ledit signal électrique souhaité traité ($S_L$) en réponse audit signal de commande (C),
   **caractérisé par**
   un extracteur (5) auquel est fourni ledit signal de surveillance (M), ledit extracteur (5) générant au moins un signal de bruit extrait ($N'_M$) représentatif de ladite composante de bruit surveillée dudit signal de surveillance (M) et un signal de composante de sortie de signal acoustique extrait ($S'_M$) représentatif de ladite composante de sortie de signal acoustique surveillée et fournit le signal de composante de sortie de signal acoustique extrait ($S'_M$) au contrôleur (6) ,
   **et en ce que**
   le contrôleur (6) génère le signal de commande à partir du signal de bruit extrait ($N'_M$) et du signal de composante de sortie de signal acoustique extrait ($S'_M$) .

2. Dispositif selon la revendication 1, dans lequel ledit contrôleur (6) génère ledit signal de commande (C) sur la base d'un rapport signal sur bruit défini comme étant le rapport dudit signal de composante de sortie de signal acoustique extrait ($S'_M$) sur ledit signal de bruit extrait ($N'_M$) .

3. Dispositif selon la revendication 1, dans lequel ledit contrôleur (6) génère ledit signal de commande (C) sur la base d'un rapport signal sur bruit défini comme étant le rapport dudit signal de composante de sortie de signal acoustique extrait ($S'_M$) sur ledit signal de bruit extrait ($N'_M$), lorsque ledit signal de bruit extrait est plus grand que ledit signal de composante de sortie de signal acoustique extrait.

4. Dispositif selon la revendication 1, dans lequel le contrôleur (6) génère le signal de commande sur la base du signal de surveillance (M).

5. Dispositif selon la revendication 1, dans lequel au moins un signal d'état correspondant à au moins l'un d'un réglage de volume, d'un régime du moteur, et de la vitesse du véhicule est fourni audit contrôleur (6) et est utilisé par ledit contrôleur (6) pour générer ledit signal de commande (C).

6. Dispositif selon la revendication 1, dans lequel ledit signal souhaité traité ($S_L$) est fourni à une entrée dudit extracteur (5).

7. Dispositif selon la revendication 1, dans lequel ledit signal électrique souhaité (S) est fourni à une entrée dudit extracteur (5).

8. Dispositif selon la revendication 1, dans lequel ledit extracteur (5) comprend en outre au moins un filtre adaptatif.

9. Procédé de réglage en fonction du bruit d'une sortie de signal acoustique rayonnée par un transducteur acoustique (3) dans un environnement, ledit procédé comprenant les étapes consistant à :

   générer un signal électrique souhaité (S),
   générer un signal électrique souhaité traité ($S_L$) à partir dudit signal électrique souhaité (S),
   ledit transducteur acoustique (3) produisant ladite sortie de signal acoustique à partir dudit signal électrique souhaité traité ($S_L$),

surveiller un signal acoustique dans ledit environnement et générer un signal de surveillance (M) à partir de celui-ci qui comprend une composante de sortie de signal acoustique associée à ladite sortie de signal acoustique et une composante de bruit acoustique,

extraire dudit signal de surveillance (M) au moins un signal de bruit extrait ($N'_M$) associé à ladite composante de bruit acoustique et un signal de composante de sortie de signal acoustique extrait ($S'_M$) associé à ladite composante de sortie de signal acoustique,

générer un signal de commande (C) à partir dudit signal de bruit extrait ($N'_M$) et dudit signal de composante de sortie de signal acoustique extrait ($S'_M$),

et faire varier ledit signal électrique souhaité traité ($S_L$) en réponse audit signal de commande (C).

10. Procédé selon la revendication 9, dans lequel le signal de commande (C) est également généré à partir dudit signal de surveillance (M).

11. Procédé selon la revendication 9, comprenant en outre l'étape consistant à extraire dudit signal de surveillance (M) un signal de composante de sortie de signal acoustique extrait ($S'_M$) associé à ladite composante de sortie de signal acoustique, et dans lequel l'étape consistant à générer ledit signal de commande (C) comprend la génération dudit signal de commande (C) sur la base d'un rapport signal sur bruit défini comme étant le rapport dudit signal de composante de sortie de signal acoustique extrait ($S'_M$) et dudit signal de bruit extrait ($N'_M$).

12. Procédé selon la revendication 9, comprenant en outre l'étape consistant à extraire dudit signal de surveillance (M) un signal de composante de sortie de signal acoustique extrait ($S'_M$) associé à ladite composante de sortie de signal acoustique, et dans lequel l'étape consistant à générer ledit signal de commande (C) comprend la génération dudit signal de commande (C) sur la base d'un rapport signal sur bruit défini comme étant le rapport dudit signal de composante de sortie de signal acoustique extrait ($S'_M$) et dudit signal de bruit extrait ($N'_M$) lorsque ledit signal de bruit extrait est supérieur audit signal de composante de signal acoustique extrait.

13. Système audio comportant une optimisation acoustique dynamique, comprenant :

une source de signal (1) fournissant un signal électrique souhaité (S),

un dispositif de régulation (2) auquel est fourni ledit signal électrique souhaité (S), qui génère un signal électrique souhaité traité ($S_L$) à partir de celui-ci,

un transducteur acoustique (3), auquel est fourni le signal électrique souhaité traité ($S_L$), qui génère une sortie de signal acoustique à partir de celui-ci, qui est rayonnée dans un environnement,

un élément d'acquisition de son (4) détectant un signal acoustique dans ledit environnement, qui comprend une composante associée à ladite sortie de signal acoustique, et une composante de bruit acoustique, l'élément d'acquisition de son (4) fournissant un signal de surveillance (M) qui comprend une composante de signal acoustique surveillée correspondant à ladite composante de sortie de signal acoustique et une composante de bruit surveillée correspondant à ladite composante de bruit acoustique,

un extracteur (5) auquel est fourni ledit signal de surveillance (M), ledit extracteur (5) générant au moins un signal de bruit extrait ($N'_M$) représentatif de ladite composante de bruit surveillée dudit signal de surveillance (M) et un signal de sortie de signal acoustique extrait ($S'_M$) représentatif de ladite composante de sortie de signal acoustique surveillée, et

un contrôleur (6) auquel sont fournis ledit signal de bruit extrait et ledit signal de sortie de signal acoustique extrait ($S'_M$), ledit contrôleur (6) générant un signal de commande (C) en réponse audit signal de bruit extrait ($N'_M$) et audit signal de sortie de signal acoustique extrait ($S'_M$), ledit signal de commande (C) étant fourni audit dispositif de régulation (2), ledit dispositif de régulation de son (2) faisant varier ledit signal électrique souhaité traité ($S_L$) en réponse audit signal de commande (C).

14. Système selon la revendication 13, dans lequel ledit contrôleur (6) génère ledit signal de commande (C) sur la base d'un rapport signal sur bruit défini comme étant le rapport dudit signal de sortie de signal acoustique extrait ($S'_M$) sur ledit signal de bruit extrait ($N'_M$) .

15. Système selon la revendication 13, dans lequel ledit contrôleur (6) génère ledit signal de commande (C) sur la base d'un rapport signal sur bruit défini comme étant le rapport dudit signal de sortie de signal acoustique extrait ($S'_M$) sur ledit signal de bruit extrait ($N'_M$) lorsque ledit signal de bruit extrait est supérieur audit signal de sortie de signal acoustique extrait.

**16.** Système selon la revendication 13, et comprenant en outre un détecteur d'activité vocale qui élimine, au moins en partie, un effet de la voix dans l'environnement dudit signal de bruit extrait,avant que ledit signal de bruit extrait ne soit utilisé par ledit contrôleur (6) pour générer ledit signal de commande (C).

_Figure - 1_

_Figure - 2_

_Figure - 3_

FIGURE 4

102 — 101

103

104

105

AF

109 108 107 106

FIGURE 5

102   111   111   111   111   101

D(z)   D(z)   D(z)   D(z)

$b_0$   $b_1$   $b_2$   $b_i$

Σ

104   112   112   112   110   12   103

FIGURE 6

FIGURE 7

FIGURE 8

FIGURE 9

FIGURE 10

$M = S_M + N_M$

AF1 $\lambda = 0.9$

AF2 $\lambda = 0.99$

$f_{92}$ — $N'_M$ (low), $S'_M$ (low)

$f_{91}$ — $N'_M$ (high), $S'_M$ (high)

$S_L$

102, 102, 103, 103', 123, 106, 103', 103, 106, 122

FIGURE 11

$i(n)$ — $\lambda_1$ — $\Sigma$ — $o(n)$

$z^{-1}$, $\lambda_1$, $z^{-1}$

124, 126, 125, 128, 127

FIGURE 12

$i(n)$

$\lambda_2$

$z^{-1}$

$-1$

$o(n)$

129, 131, 130, 134, 133, 132

FIG13

FIG 14

FIG 15

M

$N'_M$

151

$S'_M$

152

150

153

$\delta^2_1$

$\delta^2_N$

154

TH

$\delta^2_2$

155

$\delta^2_1 \leq \delta^2_2$    Y   h

156

$\delta^2_N[n] \to \delta^2_N[n-1]$

Decrement

157

$\delta^2_D$

$\delta^2_D \geq P$   h   Y   P

158

EP 1 275 200 B1

Noise[n] → [Mean | 200] → [Mean | 202] Mean Long[n] → (Threshold Value | 204) → (+) Y → ◇ X > Y ? | 206 → yes → [Reset Counter | 208]

MeanShort[n] → X

NO → [Decrement Counter | 210] → ◇ Counter = 0 ? | 212 → [Noise[n]= Noise[n-1] | 214]

[Noise[n]= MeanLong[n-1] | 218] ← [Increment Counter | 216]

37

FIGURE 16

S'M (Signal) → (V1 | 300) → [τ | 304] → L_S → ◇ L_N > L_S ? | 308 → yes → [L_S/L_N | 310] SNR → [Gain=1-SNR | 312] → (C)

NO → [Gain=10^(-V/20) | 314] → (C)

N'M (Noise) → (V2 | 302) → [τ | 306] → L_N

FIGURE 17

28

FIGURE 18

FIGURE 19

FIGURE 20

FIGURE 21

FIGURE 23

FIGURE 22

FIGURE 24

Gain as a Function of Input Level and Noise Level

Noise = 0
Noise = -10
Noise = -20
Noise = -30
Noise = -40
Noise = -50
Noise = -60
Noise = -70
Noise = -80

Figure 25

*402*

S

*404*

SL

*406*

C

*408*

$N_A \rightarrow$

$S_A \leftrightarrow$

$S_A + N$

$S_C$

$R_C$

$N'_M$

*412*

Volume,Speed,....

*410*

*400*

FIGURE 26

Decimation
Filter (optional)

Decimation
(optional)

S

S

$S_C$

*442*  *444*

$S_M + N$

FIR Filter Core

−

+

*418*  *422*

*446*

Decimation
Filter (optional)

Decimation
(optional)

$S_M + N$

.(2)

*436*  *438*  *440*

Scale
(optional)

Filter
H(z)
(optional)

Mean

f(x)

*434*

Decimation
Filter (optional)

Decimation
(optional)

.(3)

.(1)

*416*

S

Warped FIR Filter Core

$S'_M$

−

+

$N'_M$

Scale
(optional)

Filter
H(z)
(optional)

VAD
(optional)

Mean

−Corr

$R_C$

*420*  *424*

LMS

*426*  *428*  *430*  *432*

N

*414*

*410*

FIGURE 27

Figure 28

450

452

FIGURE 29

FIGURE 30

FIGURE 81

FIGURE 32

412

FIGURE 33

412

Compressor Curve as a function of Input Level (S) and Noise Level (N), e.g., at a Volume = 6 dB

Legend:
— Noise = 0 [dB]
— Noise = 10 [dB]
— Noise = 20 [dB]
— Noise = 30 [dB]
— Noise = 40 [dB]
— Noise = 50 [dB]
— Noise = 60 [dB]
— Noise = 70 [dB]
— Noise = 80 [dB]
— Noise = 90 [dB]
— Noise = 100 [dB]

FIGURE 34

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0319777 A2
- US 5450494 A
- DE 4314451 A1
- US 5434922 A
- US 5615270 A

**Non-patent literature cited in the description**

- **HAYKIN.** Adaptive Filter Theory. Prentice Hall, 1991
- **J. G. PROAKIS.** Digital Communication. McGraw Hill, 1995, 634-676
- **D. A. PIERRE.** Optimization Theory with Applications. Wiley and Sons, 1969
- **L.R. RABINER ; R.W. SCHAFER.** Digital Signal Processing of Speech Signals. Prentice Hall, 1978